(19) Europäisches Patentamt / European Patent Office / Office européen des brevets

(11) **EP 4 040 173 B1**

(12) **FASCICULE DE BREVET EUROPEEN**

(45) Date de publication et mention
de la délivrance du brevet:
**11.09.2024  Bulletin 2024/37**

(21) Numéro de dépôt: **22155195.5**

(22) Date de dépôt: **04.02.2022**

(51) Classification Internationale des Brevets (IPC):
***G01R 31/327*** *(2006.01)*

(52) Classification Coopérative des Brevets (CPC):
**G01R 31/3278**

(54) **PROCÉDÉ D ESTIMATION D'UN ÉTAT DE FONCTIONNEMENT D'UN APPAREIL DE COMMUTATION ÉLECTRIQUE ET APPAREIL DE COMMUTATION ÉLECTRIQUE POUR LA MISE EN  OEUVRE D'UN TEL PROCÉDÉ**

VERFAHREN ZUM EINSCHÄTZEN EINES BETRIEBSZUSTANDS EINES ELEKTRISCHEN SCHALTGERÄTS UND ELEKTRISCHES SCHALTGERÄT ZUR UMSETZUNG DIESES VERFAHRENS

METHOD FOR ESTIMATING A STATE OF OPERATION OF AN ELECTRICAL SWITCHING DEVICE AND ELECTRICAL SWITCHING DEVICE FOR IMPLEMENTING SUCH A METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **04.02.2021   FR 2101081**

(43) Date de publication de la demande:
**10.08.2022   Bulletin 2022/32**

(73) Titulaire: **Schneider Electric Industries SAS
92500 Rueil-Malmaison (FR)**

(72) Inventeurs:
• **ORBAN, Rémy
  38410 SAINT MARTIN D'URIAGES (FR)**
• **GEFFROY, Vincent
  SHANGHAI, 200120 (CN)**

(74) Mandataire: **Lavoix
  62, rue de Bonnel
  69448 Lyon Cedex 03 (FR)**

(56) Documents cités:
FR-A1- 2 919 109        JP-A- 2006 004 902
US-A1- 2009 138 212    US-A1- 2019 074 148
US-B1- 6 249 418

**Description**

La présente invention concerne un procédé d'estimation d'un état de fonctionnement d'un appareil de commutation électrique et un appareil de commutation électrique pour la mise en oeuvre d'un tel procédé.

L'invention concerne plus particulièrement les contacteurs électriques.

De tels appareils de commutation électrique comportent un actionneur électromagnétique comprenant une bobine fixe et un noyau mobile et sont configurés pour commuter entre un état ouvert et un état fermé, par exemple pour commander l'alimentation électrique d'une charge électrique. Généralement, les contacts électriques comprennent des contacts fixes et des contacts mobiles, ces derniers étant reliés au noyau mobile qui se déplace sous l'effet d'un champ magnétique créé par la bobine lorsque celle-ci est parcourue par un courant électrique adéquat.

À chaque cycle de commutation, le contacteur s'use sous l'effet de divers facteurs. Par exemple les contacts électriques s'usent sous l'effet d'arcs électriques créés lors de l'ouverture des contacts électriques, et les frottements au sein du mécanisme croissent sous l'effet d'accumulation de poussière et/ou de particules liées à l'usure des pièces, ce qui dégrade les performances de l'actionneur.

Il est souhaitable de pouvoir estimer automatiquement les états d'un contacteur lorsqu'il est en fonctionnement, afin de prévoir une maintenance adaptée au cours de la vie dudit contacteur et/ou de détecter l'apparition de dysfonctionnements.

Intégrer à l'actionneur électromagnétique un capteur de position, pour mesurer directement le déplacement ou la position des pièces mobiles de l'actionneur et en déduire un état du contacteur, n'est souvent pas une solution appropriée, car le recours à un capteur rend l'actionneur plus coûteux et plus complexe à fabriquer, et il n'est pas toujours possible d'intégrer un capteur à un contacteur.

WO-03/054895-A1 décrit une méthode de diagnostic basée sur une mesure du temps de parcours du noyau mobile de l'actionneur électromagnétique au cours de la phase de fermeture. Une telle méthode de diagnostic est applicable seulement lorsque le noyau est en mouvement et n'est donc pas utilisable pendant les autres phases de fonctionnement de l'actionneur.

US-6 249 418-B1 décrit des méthodes de contrôle de la force et/ou du mouvement d'un actionneur électromagnétique, par exemple une bobine, lorsque l'actionneur est en mouvement.

US-2019/074148-A1, US-2009/138212 et JP-2006 004902-1 décrivent chacun un appareil de commutation comprenant un actionneur électromagnétique, avec une bobine et un noyau mobile, et une armature métallique intégrant des capteurs de flux magnétique, par exemple des capteurs à effet Hall. Ces capteurs mesurent des flux magnétiques traversant cette armature. Alors que l'actionneur est en mouvement, des flux magnétiques, différents du flux bobine, sont calculés, pour évaluer des états de l'actionneur électromagnétique, notamment une vitesse de déplacement du noyau mobile.

C'est à ces problèmes qu'entend plus particulièrement remédier l'invention, en proposant un procédé de diagnostic qui soit plus précis.

À cet effet, l'invention concerne un procédé pour estimer l'état d'un appareil de commutation électrique, l'appareil de commutation comportant des contacts électriques séparables configurés pour être couplés à un conducteur électrique, et un actionneur électromagnétique, piloté par un circuit de commande et comportant un noyau mobile, couplé aux contacts séparables, et une bobine, traversée par un courant bobine. Selon l'invention, le procédé comporte des étapes consistant à :

- mesurer, au moyen de capteurs associés à la bobine, une valeur du courant bobine au cours d'un intervalle de temps, pendant que l'actionneur électromagnétique est maintenu dans une position stable, notamment de fermeture,
- calculer, au moyen d'un dispositif électronique de contrôle de l'appareil de commutation, une ou plusieurs valeurs d'un flux magnétique de la bobine, à partir de la valeur de courant bobine mesurée, et à l'aide de valeurs de tension bobine et de résistance bobine préalablement connues.

Grâce à l'invention, les variations de flux magnétiques sont évaluées même lorsque le noyau est immobile. La valeur de flux magnétique étant différente selon que le noyau mobile de l'actionneur électromagnétique est en position ouverte ou fermée, la mesure de flux magnétique permet d'évaluer l'état de l'actionneur sans nécessiter d'ajouter un capteur supplémentaire, ce qui permet un diagnostic plus précis de l'état de l'appareil de commutation.

Selon des aspects avantageux mais non obligatoires de l'invention, un tel procédé peut incorporer une ou plusieurs des caractéristiques suivantes prises isolément ou selon toute combinaison techniquement admissible :

- les une ou plusieurs valeurs d'un flux magnétique sont calculées par intégration de la formule ci-dessous :

$$\phi = \int \frac{U_{BOB} - R_{BOB} \cdot I_{BOB}}{N_{BOB}} dt$$

dans laquelle $N_{BOB}$ est un nombre de spires de la bobine.

- Une première valeur du flux magnétique est calculée à partir de mesures du courant bobine réalisées alors que l'appareil de commutation est dans un mode de roue-libre, dans lequel la tension bobine est limitée passivement par le circuit de commande, tandis que le courant bobine décroît librement, l'énergie électrique étant principalement dissipée par la résistance bobine.
- Une deuxième valeur du flux magnétique est calculée à partir de mesures du courant bobine réalisées au cours d'une portion croissante qui précède immédiatement la phase de roue libre au cours de laquelle sont réalisées les mesures du courant bobine servant au calcul de la première valeur de flux magnétique, la tension bobine étant imposée par le circuit de commande.
- La première valeur du flux magnétique et la deuxième valeur du flux magnétique sont calculées à partir de mesures du courant bobine réalisées au cours d'une phase de fermeture du l'appareil de commutation.
- Un pic de courant bobine est appliqué à l'aide du dispositif électronique de contrôle au cours d'une phase de test inclue dans une phase de maintien de l'appareil de commutation, au cours de laquelle le courant bobine présente une valeur de courant de maintien strictement supérieure à une valeur de décrochage du courant bobine, en deçà de laquelle l'actionneur électromagnétique n'est pas maintenu excité en position de fermeture, l'évolution du courant bobine présentant une portion croissante, au cours de laquelle sont réalisées les mesures du courant bobine servant au calcul de la deuxième valeur du flux magnétique, et une portion décroissante, au cours de laquelle sont réalisées les mesures du courant bobine servant au calcul de la première valeur du flux magnétique.
- La résistance bobine est mesurée au cours d'une portion stable de la phase de maintien, qui précède la phase de test, la valeur mesurée de la résistance bobine étant ensuite utilisée à l'étape de calcul de la deuxième valeur du flux magnétique et de la première valeur du flux magnétique au cours de ladite phase de test.
- La ou les valeurs calculées de flux magnétique sont normalisées et combinées à au moins une autre grandeur électrique, mesurée et/ou calculée, de l'appareil électrique de commutation, chaque autre mesure de grandeur électrique étant aussi normalisée, pour résulter en un indicateur intermédiaire sur l'état de l'actionneur électromagnétique.
- Une phase de fermeture de l'appareil de commutation comprend une phase dynamique, au cours de laquelle la tension bobine est pilotée par le dispositif électronique de commande, suivie d'une phase de transition, au cours de laquelle l'appareil de commutation est dans un mode de roue-libre,

    alors qu'au cours de la phase dynamique l'évolution du courant bobine augmente une première fois au-delà d'un premier seuil, qui est lié à un courant de décollage de l'appareil de commutation au-delà duquel le noyau mobile commence à se déplacer de sa position d'ouverture vers sa position de fermeture, puis l'évolution du courant bobine décroît en deçà du premier seuil, atteint une valeur minimale, puis repasse une deuxième fois au-delà du premier seuil ;
    que l'on définit un deuxième seuil du courant bobine, le deuxième seuil étant compris entre le premier seuil et la valeur minimale,
    que le courant bobine mesuré est inférieur au deuxième seuil, et à condition que l'évolution du courant bobine dépasse une deuxième fois le premier seuil, on calcule une intégrale de la différence entre le courant bobine et le deuxième seuil, sur un intervalle de temps défini entre un premier instant où l'évolution du courant bobine décroît en deçà du deuxième seuil et un deuxième instant où le courant bobine repasse au-dessus du deuxième seuil,
    et que ladite intégrale est l'une des autres grandeurs électriques combinées pour former l'indicateur intermédiaire.

- On mesure, au moyen de capteurs associés à la bobine, une valeur du courant bobine au cours d'un intervalle de temps, pendant que l'actionneur électromagnétique est maintenu dans une position stable, notamment de fermeture, et que l'appareil de commutation est dans un mode de roue-libre, dans lequel la tension bobine est limitée passivement par le circuit de commande, tandis que le courant bobine décroit librement, l'énergie électrique étant principalement dissipée par la résistance bobine ,

    alors que l'on calcule, au moyen d'un dispositif électronique de contrôle de l'appareil de commutation, une valeur d'inductance bobine de la bobine à partir de la valeur de courant bobine mesurée, et à l'aide de valeurs de tension bobine et de résistance bobine préalablement connues ;
    et que l'inductance bobine est l'une des autres grandeurs électriques utilisées pour former l'indicateur intermédiaire.

- L'actionneur électromagnétique comprend un circuit magnétique réalisé en un matériau, dans lequel l'inductance bobine est calculée à partie de mesures du courant bobine réalisées dans un domaine du courant bobine où le matériau du circuit magnétique présente une saturation magnétique inférieure à 80% d'une saturation magnétique maximale de ce matériau, de préférence inférieure à 50%.
- Les étapes de mesure du courant bobine et de calcul de l'inductance bobine sont répétées au cours de plusieurs intervalles de temps, une valeur d'inductance moyenne étant déduite à partir des valeurs d'inductance bobine calculées au cours de chaque intervalle de temps,

  alors que chaque intervalle de temps présente une durée comprise entre 0,01 ms et 10 ms, de préférence comprise entre 0,1 ms et 1 ms, de préférence encore égale à 0,2 ms,
  et que la valeur de l'inductance bobine est moyennée sur au moins dix intervalles de temps, de préférence sur au moins vingt intervalles de temps.

- L'une des autres mesures de grandeur électrique est une mesure d'un courant de pôle, traversant un pôle du conducteur électrique, et/ou un état de commande du dispositif électronique de contrôle.

Selon un autre aspect, l'invention concerne un appareil de commutation électrique pour la mise en oeuvre d'un procédé d'estimation tel que décrit précédemment, l'appareil de commutation étant configuré pour être couplé à un conducteur électrique et comprenant :

- des contacts séparables, déplacés entre une position ouverte et une position fermée par un actionneur électromagnétique comprenant une bobine et un noyau mobile lié aux contacts séparables,
- un circuit de commande de la tension électrique aux bornes de la bobine, dite « tension bobine », le circuit de commande comprenant un dispositif dit « de retombée », activable sélectivement pour faire chuter le courant électrique circulant au travers de la bobine, dit « courant bobine », la tension bobine et le dispositif de retombée étant activés ou désactivés selon des états du circuit de commande ;
- des capteurs associés à la bobine pour mesurer le courant bobine ;
- un dispositif électronique de contrôle, configuré pour recevoir des ordres d'ouverture et de fermeture de l'appareil de commutation, pour recevoir les valeurs des mesures de courant bobine et pour commander les états du circuit de commande ;

dans lequel, alors que l'actionneur électromagnétique est maintenu dans une position stable, notamment de fermeture, l'appareil de commutation est configuré pour mettre en oeuvre un procédé de diagnostic comprenant des étapes consistant à :

- mesurer, au moyen des capteurs associés à la bobine, des valeurs de courant bobine au cours d'un intervalle de temps,
- calculer, au moyen du dispositif électronique de contrôle, une valeur d'un flux magnétique de la bobine, à partir des valeurs de courant bobine mesurées, et à l'aide de valeurs, préalablement connues, de la tension bobine et de résistance bobine.

L'invention sera mieux comprise, et d'autres avantages de celle-ci apparaîtront plus clairement à la lumière de la description qui va suivre, de deux modes de réalisation d'un procédé conformes à son principe et d'un appareil de commutation électrique pour la mise en oeuvre de ces procédés, donnée uniquement à titre d'exemple et faite en référence aux dessins, dans lesquels :

- [Fig 1] la figure 1 est une vue schématique d'un appareil de commutation électrique comportant un actionneur électromagnétique conforme à des modes de réalisation de l'invention ;
- [Fig 2] la figure 2 une vue schématique d'un exemple du circuit de commande de l'actionneur électromagnétique de l'appareil de commutation de la figure 1 ;
- [Fig 3] la figure 3 est un graphe représentant l'évolution d'un courant électrique de commande de l'actionneur électromagnétique de la figure 2 au cours de plusieurs phases de fonctionnement ;
- [Fig 4] la figure 4 est un graphe représentant l'évolution de grandeurs électriques de l'actionneur électromagnétique, selon que l'actionneur est ouvert ou fermé ;
- [Fig 5] la figure 5 est un graphe représentant le détail V sur la figure 3, au cours d'une phase de maintien de l'actionneur électromagnétique ;

- [Fig 6] la figure 6 illustre, sur deux inserts a) et b), un exemple de méthode de normalisation de grandeurs électriques de l'actionneur électromagnétique de la figure 2, selon que l'actionneur est ouvert ou fermé ;
- [Fig 7] la figure 7 est un graphe représentant le détail VII sur la figure 3, au cours d'une phase de fermeture de l'actionneur électromagnétique;
- [Fig 8] la figure 8 est un graphe représentant un exemple d'indicateur d'état de l'actionneur électromagnétique, l'indicateur utilisant la méthode de normalisation de la figure 6, et
- [Fig 9] la figure 9 est un diagramme représentant des étapes d'un procédé d'estimation d'un état de l'appareil de commutation de la figure 1, conforme à des modes de réalisation de l'invention.

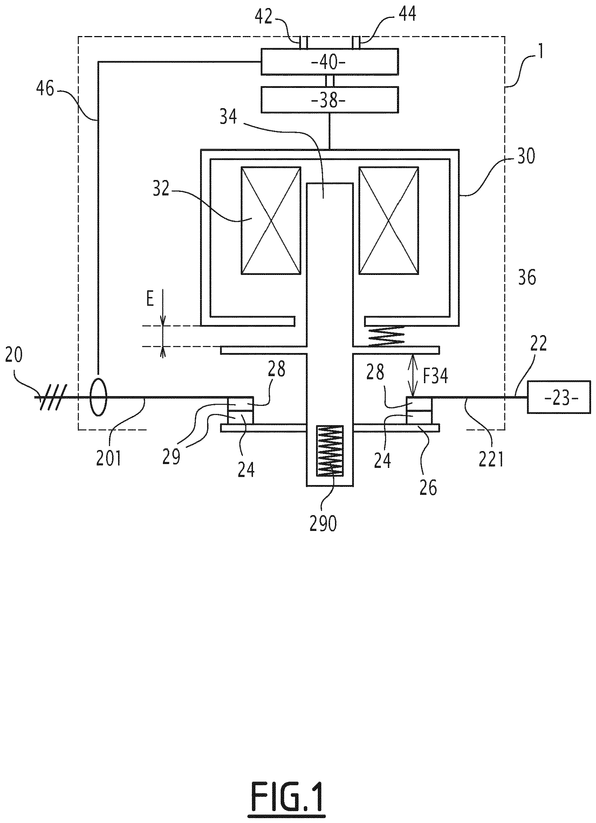

Un contacteur 1 est représenté sur la figure 1. Le contacteur 1 est un exemple d'appareil de commutation électrique destiné à commander l'alimentation en énergie électrique d'une source d'énergie électrique vers une charge électrique 23. La source d'énergie électrique n'est pas dessinée pour simplifier les figures. La source d'énergie est par exemple un réseau d'alimentation électrique, tandis que la charge électrique 23 est par exemple un moteur électrique, que l'on souhaite commander au moyen du contacteur 1. Le contacteur 1 est généralement logé dans un boitier, représenté ici par un rectangle en pointillés. Le contacteur 1 est configuré pour être couplé, d'une part, à un conducteur électrique 20 amont connecté à une source d'énergie électrique et, d'autre part, à une ligne aval 22 connectée à la charge électrique 23. Lorsque le contacteur 1 laisse passer le courant électrique et que la charge électrique 23 est alimentée en énergie, le contacteur 1 est dans un état dit « fermé », tandis que lorsque le contacteur 1 empêche le passage de l'énergie électrique vers la charge électrique, le contacteur 1 est dans un état dit « ouvert ».

Le conducteur électrique 20 et la ligne aval 22 comprennent le même nombre de phases. Lorsque la source d'énergie électrique est polyphasée, les conducteurs électriques 20 et la ligne aval 22, qui comprennent chacune des membres conducteurs isolés les uns des autres, comptent autant de membres conducteurs l'un que l'autre, chaque membre conducteur de la ligne aval 22 étant associé à un membre respectif du conducteur électrique 20 amont. Quel que soit le nombre de phases, le contacteur 1 est configuré pour interrompre, ou faire passer, le courant électrique conjointement dans chacune des phases.

Dans l'exemple illustré, le conducteur électrique 20 amont est triphasé. Les membres conducteurs sont ici des fils conducteurs. Un seul des fils conducteurs du conducteur électrique 20, référencé 201, est représenté sur la figure 1. Seul le fil conducteur de la ligne de puissance 22 associé au conducteur 201 est représenté, ce fil conducteur de la ligne de puissance 22 étant référencé 221. En variante non limitative, les membres conducteurs sont des bus rigides.

La suite de la description est faite en référence aux fils conducteurs 201 et 221, qui sont associés à une même phase du courant d'alimentation, sachant que ce qui est décrit est transposable aux autres phases du courant d'alimentation.

Pour chaque phase, le contacteur 1 comprend des contacts mobiles 24, disposés sur un barreau mobile 26, et des contacts fixes 28, liés respectivement aux conducteurs amont 20 et aval 22. Chacun des contacts mobiles 24 et fixes 28 comprend des pastilles de contact 29, réalisées ici en métal, de préférence en alliage d'argent ou tout matériau équivalent.

Le barreau mobile 26 est déplaçable entre une position fermée, dans laquelle les contacts mobiles 24 sont électriquement connectés aux contacts fixes 28 et l'énergie électrique peut circuler au travers du barreau mobile 26 du conducteur électrique 20 amont vers la ligne aval 22, et une position ouverte, dans laquelle les contacts mobiles 24 sont éloignés des contacts fixes 28.

Lorsque le barreau mobile 26 est en position fermée, le contacteur 1 est à l'état fermé, tandis que lorsque le barreau 26 est en position ouverte, le contacteur 1 est à l'état ouvert. Le passage de l'état ouvert à l'état fermé est une phase de fermeture du contacteur 1, tandis que le passage de l'état fermé à l'état ouvert est une phase d'ouverture du contacteur 1.

En pratique, au cours de chaque cycle comprenant une phase de fermeture et d'ouverture, les pastilles de contact 29 s'usent, par exemple sous l'action d'arcs électriques au cours de l'ouverture, ou encore par arrachement de matière causé par des microsoudures. Cette perte de matière a pour conséquence que l'épaisseur des pastilles de contact 29 se réduit tout au long de la vie du contacteur 1, ce qui augmente l'amplitude du mouvement du barreau 26 lors des phases d'ouverture ou de fermeture. Pour y remédier, le contacteur 1 comprend un mécanisme 290, représenté schématiquement par un ressort sur la figure 1, qui est lié au barreau 26 et qui permet de maintenir les contacts fixes 28 et mobiles 24 en contact électrique avec une pression de contact suffisante.

Le barreau mobile 26 est piloté par un actionneur électromagnétique 30, qui comprend électroaimant de commande avec une bobine 32, un noyau 34 lié au barreau mobile 26 et un organe de rappel 36, par exemple un ressort ou équivalent. La bobine 32 est configurée pour générer un champ magnétique lorsqu'elle est alimentée par un courant électrique de commande, afin de mettre en mouvement le noyau 34, et donc le barreau mobile 26. L'actionneur électromagnétique 30 est ici un actionneur linéaire, qui présente une reluctance $Rel$ variable, dépendant notamment de la position du noyau 34.

Les mouvements du noyau 34 entre les positions ouverte et fermée sont représentés par une double flèche F34. Autrement dit, les contacts mobiles 24 et les contacts fixes 28 associés forment ensemble des contacts séparables, qui sont associés au conducteur électrique 20 et qui sont déplacés entre une position ouverte et une position fermée par l'actionneur électromagnétique 30, qui comprend une bobine 32 et un noyau mobile 34 lié aux contacts séparables.

Sur la figure 1, le contacteur 1 est représenté dans une configuration intermédiaire entre les états ouvert et fermé stable du contacteur 1, dans laquelle les contacts fixes 28 et mobiles 24 sont électriquement connectés, mais le noyau 34 n'est pas en butée en position fermée. Le mécanisme 290 autorise une sur-course E du noyau 34 entre le moment où les contacts fixes 28 entrent en contact avec les contacts mobiles 24, et le moment ou l'actionneur électromagnétique 30 est en position fermée stable.

L'actionneur électromagnétique 30 est commandé par l'intermédiaire d'un circuit d'alimentation 38, lui-même piloté par un dispositif électronique de contrôle 40. La bobine 32 est ainsi reliée au dispositif électronique de contrôle 40.

Selon des modes de réalisation, le dispositif électronique de contrôle 40 comporte une unité logique de calcul - dite aussi CPU en anglais -, telle qu'un microcontrôleur programmable ou un microprocesseur ou équivalent, et une mémoire informatique formant un support d'enregistrement de données lisibles par ordinateur.

Selon des exemples, la mémoire est une mémoire ROM, ou une mémoire RAM, ou une mémoire non volatile du type EPROM ou Flash ou équivalent. La mémoire comporte des instructions exécutables et/ou du code informatique pour assurer le fonctionnement du dispositif de contrôle 40 conformément à un ou plusieurs des modes de réalisation décrits ci-après lorsqu'exécuté par l'unité logique de calcul.

Selon des variantes, le dispositif électronique de contrôle 40 peut comporter un processeur de traitement du signal (DSP), ou un composant logique reprogrammable (FPGA), ou un circuit intégré spécialisé (ASIC), ou tout élément équivalent.

Le dispositif électronique de contrôle 40 est lui-même connecté à un rail d'alimentation 42 et comprend une interface 44 configurée pour recevoir, en provenance d'un utilisateur, des ordres d'ouverture ou de fermeture du contacteur 1. Le dispositif électronique de contrôle 40 est ici représenté comme étant intégré au contacteur 1. En variante le dispositif de contrôle 40 est déporté, c'est-à-dire qu'il n'est pas intégré dans un même boitier que l'actionneur électromagnétique 30.

Le rail d'alimentation 42 est destiné à alimenter en énergie le dispositif électronique de contrôle 40 ainsi que le circuit d'alimentation 38. Selon les cas, le rail d'alimentation 42 présente une tension électrique continue ou alternative. La méthode décrite ici est adaptée pour un rail d'alimentation 42 présentant une tension alternative ou continue, dont l'amplitude est typiquement comprise entre 24 V et 500 V. Dans l'exemple illustré, la tension du rail d'alimentation 42 est une tension alternative à 50 Hz, à 230 V.

L'interface 44 est représentée ici par des électrodes de commande. Par exemple, une tension électrique de commande peut être appliquée entre les électrodes de commande. Optionnellement, l'interface 44 comprend des moyens de communication sans fil.

Dans certains modes de réalisation, le contacteur 1 comprend aussi des capteurs de courant 46, configurés pour mesurer un courant circulant dans chacune des phases de la ligne amont 20, autrement dit un courant circulant dans chacun des fils conducteurs 201 de la ligne amont 20. Dans d'autres modes de réalisation, les capteurs de courant 46 et le dispositif électronique de contrôle 40 sont intégré dans un boîtier distinct du contacteur 1.

Lorsque la bobine 32 est alimentée en énergie électrique fournie par le rail d'alimentation 42, un courant d'excitation passe par la bobine 32, qui génère une force électromagnétique qui tend à attirer le noyau 34 et le barreau 26 de la position ouverte vers la position fermée. Un organe de rappel 36, représenté ici par un ressort, exerce une force de rappel qui s'oppose à la force d'attraction de l'électroaimant.

On définit un courant bobine $I_{BOB}$ comme étant un courant d'excitation circulant au travers de la bobine 32.

On définit un courant de décollage $I_D$ comme étant un seuil du courant bobine $I_{BOB}$ qui, lorsque l'actionneur 30 est à l'état ouvert, permet à l'actionneur 30 de se déplacer jusqu'à l'état fermé, dès que le courant bobine $I_{BOB}$ croît au-delà du courant de décollage $I_D$.

On définit un courant de décrochage $I_S$ - ou « *stall current* » en anglais - comme étant un seuil du courant bobine $I_{BOB}$ qui, lorsque l'actionneur 30 est à l'état fermé, permet à l'actionneur 30 de se déplacer jusqu'à l'état ouvert, dès que le courant bobine $I_{BOB}$ décroit en deçà du courant de décrochage $I_S$.

Ainsi, lorsque l'actionneur 30 est à l'état ouvert, tant que le courant bobine $I_{BOB}$ reste en-deçà du courant de décollage $I_D$, le noyau mobile 34 est repoussé en position ouverte par l'organe de rappel 36 de l'actionneur 30 et le contacteur 1 reste à l'état ouvert. Si le courant bobine $I_{BOB}$ croit au-delà du courant de décollage $I_D$, la force électromagnétique de la bobine 32 devient supérieure à la force de rappel de l'organe 36 et le noyau 34 se déplace alors de sa position ouverte vers sa position fermée. Une telle situation correspond à une phase de fermeture du contacteur 1.

À l'inverse, lorsque l'actionneur 30 est à l'état fermé, tant que le courant bobine $I_{BOB}$ reste supérieur au courant de décrochage $I_S$, le contacteur 1 reste à l'état fermé. Si, alors que le contacteur 1 est à l'état fermé, le courant bobine $I_{BOB}$ décroit en-deçà du courant de décrochage $I_S$, la force électromagnétique de la bobine 32 devient plus faible que la force de rappel de l'organe 36 et du mécanisme 290, le noyau 34 est alors repoussé de sa position fermée vers sa position ouverte sous l'effet de l'organe de rappel 36 et du mécanisme 290. Une telle situation correspond à une phase d'ouverture du contacteur 1.

Généralement, le courant de décollage $I_D$ est supérieur, en valeur absolue, au courant de décrochage $I_S$. Les valeurs des courants de décollage $I_D$ et de décrochage $I_S$ sont ajustées lors de la conception de l'actionneur 30, en jouant notamment sur les propriétés de la bobine 32 ou sur les forces de rappel de l'organe 36 et du mécanisme 290.

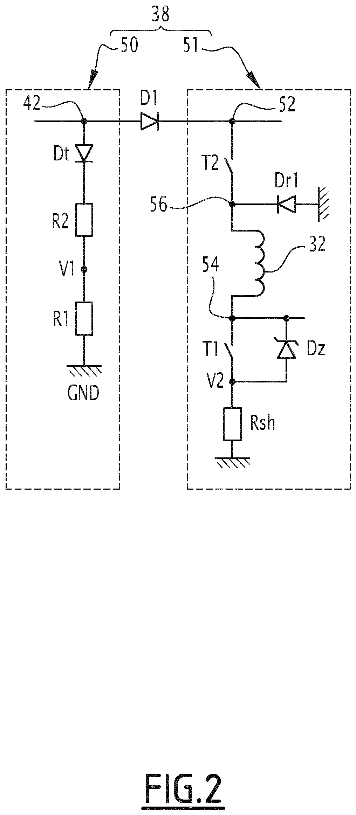

Un exemple de réalisation du circuit d'alimentation 38 est représenté schématiquement sur la figure 2. L'architecture du circuit d'alimentation 38 n'est pas limitative, et d'autres implémentations des divers composants du circuit d'alimentation 38 sont possibles, voire d'autres composants électriques ou électroniques peuvent être utilisés pour remplir les mêmes fonctions.

Le circuit d'alimentation 38 comprend de préférence un circuit de mesure 50, délimité par un cadre en pointillés, configuré pour mesurer la valeur de la tension électrique entre le rail d'alimentation 42 et une masse électrique GND du circuit d'alimentation 38.

Par exemple, le circuit de mesure 50 comprend deux résistances R1 et R2 connectées en série avec une diode Dt entre le rail d'alimentation 42 et la masse électrique GND. Un premier point de mesure, ici placé entre les résistances R1 et R2, permet de collecter une première tension de mesure V1 représentative de la tension électrique présente entre le rail d'alimentation 42 et la masse électrique GND. La tension électrique présente entre le rail 42 et la masse GND étant reliée à la tension bobine $U_{BOB}$, par extension le circuit de mesure 50 est un exemple de capteur configuré pour mesurer la tension bobine $U_{BOB}$.

Le circuit d'alimentation 38 comprend un circuit de commande 51, qui inclut la bobine 32. Une diode D1 peut être placée sur le rail d'alimentation 42 entre le circuit de commande 51 et le circuit de mesure 50 pour éviter tout retour de courant vers ce dernier. Les diodes D1 et Dt sont de préférence de même type.

Le circuit de commande 51 est représenté ici dans une configuration dite « de retombée », qui est détaillée plus loin dans la présente description.

Le circuit de commande 51 comprend une borne d'alimentation 52, qui est reliée au rail d'alimentation 42. La bobine 32 comprend deux bornes 54 et 56. Une mesure de tension électrique entre les bornes 54 et 56 permet ainsi de mesurer une tension bobine, notée $U_{BOB}$.

La borne 54 est reliée à la masse GND par l'intermédiaire d'un interrupteur dit « de retombée » T1. Dans de nombreux modes de réalisation, une résistance dite « de shunt » Rsh est connectée en série avec l'interrupteur de retombée T1 pour collecter une deuxième tension de mesure V2 représentative du courant électrique traversant la bobine 32, autrement dit représentative du courant bobine $I_{BOB}$. Dans l'exemple illustré la résistance de shunt Rsh est connectée entre l'interrupteur de retombée T1 et la masse GND. La résistance Rsh est un exemple de capteur configuré pour mesurer l'intensité du courant bobine $I_{BOB}$ circulant dans la bobine 32.

La borne 56 est, d'une part, reliée à la borne 52 par l'intermédiaire d'un interrupteur d'alimentation T2 et, d'autre part, reliée à la masse GND par l'intermédiaire d'une diode, dite diode « de roue libre » Drl. La diode de roule libre Drl présente un sens bloquant orienté vers la borne 56.

Les interrupteurs T1 et T2 sont des interrupteurs pilotés par un signal de commande en provenance du dispositif électronique de contrôle 40. Autrement dit, le dispositif électronique de contrôle 40 est configuré pour commander des états du circuit de commande 51.

Selon des exemples de mise en oeuvre, les interrupteurs T1 et T2 sont des interrupteurs de puissance à semi-conducteurs, tels que des transistors Mosfet, ou des thyristors, ou des transistors bipolaires à grille isolée (IGBT), ou tout autre dispositif équivalent.

Le circuit de commande 51 comprend un dispositif « de retombée » Dz, réalisé ici au moyen d'une diode Zéner et connecté en parallèle à l'interrupteur de retombée T1. Ainsi, lorsque l'interrupteur de retombée T1 est ouvert, le courant bobine $I_{BOB}$ passe par le dispositif de retombée Dz, alors que lorsque l'interrupteur de retombée T1 est fermé, le dispositif de retombée Dz est en court-circuit et aucun courant ne passe par le dispositif de retombée Dz. Le dispositif de retombée Dz est ainsi activable sélectivement pour faire chuter le courant bobine $I_{BOB}$.

La bobine 32 présente une résistance bobine notée $R_{BOB}$ et une inductance bobine notée $L_{BOB}$. La résistance $R_{BOB}$ et l'inductance $L_{BOB}$ dépendent, notamment, de la géométrie de la bobine 32, des matériaux utilisés, de la température, etc. Dans les deux modes de réalisation du procédé, l'inductance $L_{BOB}$ est mesurée, comme expliqué plus loin dans la présente description. Dans le premier mode de réalisation du procédé, la résistance bobine $R_{BOB}$ est mesurée, tandis que dans le deuxième mode de réalisation de l'invention, la résistance bobine $R_{BOB}$ est considérée comme connue, comme expliqué plus loin.

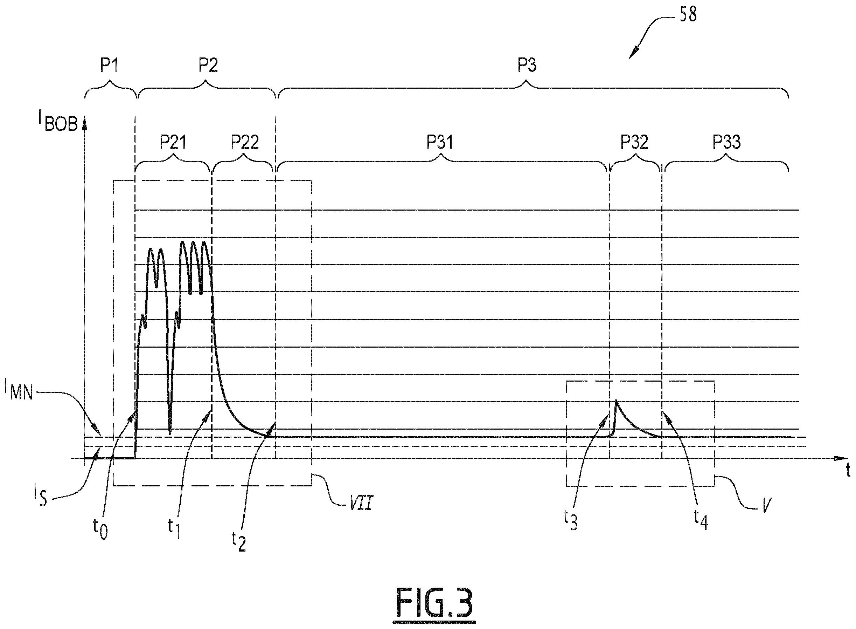

La figure 3 représente un graphique 58 illustrant l'évolution du courant bobine $I_{BOB}$ circulant dans la bobine 32 au cours du temps $t$ lors de différentes phases de fonctionnement successives du contacteur 1, notées P1, P2 et P3, dans le cas où le contacteur est commuté depuis l'état ouvert vers l'état fermé.

La phase P1 est une phase initiale, pendant laquelle le contacteur 1 est à l'état ouvert de façon stable, c'est-à-dire que le courant bobine $I_{BOB}$ ne dépasse pas le courant de décollage $I_D$. Dans l'exemple de la figure 3, le courant bobine $I_{BOB}$ reste nul au cours de la phase initiale P1.

La phase P2 correspond à une phase de fermeture, après qu'un ordre de fermeture ait été reçu par le contacteur 1. La phase P2 commence lorsque le dispositif électronique de contrôle 40 reçoit, à un instant $t_0$, un ordre de fermeture par l'interface 44.

Le dispositif électronique de contrôle 40 est configuré pour appliquer la tension bobine $U_{BOB}$ de commande aux bornes de la bobine 32. Par exemple, le dispositif de contrôle 40 commande alors l'interrupteur de retombée T1 et de l'interrupteur d'alimentation T2, de manière à réguler la tension bobine $U_{BOB}$ en fonction de la tension du rail d'alimentation 42.

Dans l'exemple illustré, la tension du rail 42 est alternative : on comprend bien que la bobine 32 ne pourrait pas fonctionner en étant branchée directement sur le rail d'alimentation 42. En pratique, alors que l'interrupteur de retombée T1 est fermé, le dispositif de contrôle 40 pilote la fermeture et l'ouverture de l'interrupteur d'alimentation T2, autrement dit pilote la commutation de l'interrupteur d'alimentation T2 pour hacher la tension du rail d'alimentation 42, de manière que la tension bobine $U_{BOB}$ et le courant bobine $I_{BOB}$ soient stables et adaptés au fonctionnement de la bobine 32.

De nombreuses méthodes de régulation existent, notamment par hachage de tension. Le brevet EP-2984671 B1 donne des exemples de ces méthodes. Dans l'exemple illustré, la méthode par hachage de tension est utilisée.

Le dispositif de contrôle 40 pilote régule la commutation de l'interrupteur d'alimentation T2 à une fréquence de hachage choisie pour ne pas générer de bruit audible par les humains, par exemple une fréquence de hachage inférieure à 100 Hz ou supérieure à 20 kHz. D'autre part, plus la fréquence de hachage est élevée, et plus il est facile de réguler le courant bobine $I_{BOB}$. La fréquence de hachage est généralement comprise entre 20 kHz et 100 kHz. Dans l'exemple illustré, la fréquence de hachage est stable et égale à 20 kHz.

Au cours de chaque cycle de hachage, l'interrupteur d'alimentation T2 est fermé pendant une fraction de ce cycle de hachage, définissant un rapport cyclique $\alpha$. Le rapport cyclique $\alpha$ est un paramètre variant continûment entre 0 et 1, les bornes 0 et 1 étant incluse. Autrement dit, au cours du même cycle de hachage, l'interrupteur d'alimentation T2 est ouvert pendant une fraction du cycle égale à $1-\alpha$. Le dispositif de contrôle 40 détermine ainsi le rapport cyclique $\alpha$ en fonction de la différence entre une consigne et une mesure du courant bobine $I_{BOB}$.

La phase de fermeture P2 comprend une phase dynamique P21, au cours de laquelle la tension bobine $U_{BOB}$ est pilotée par le dispositif électronique de commande 40. Autrement, dit, le rapport cyclique $\alpha$ n'est pas toujours nul, et la bobine 32 est alimentée en énergie électrique provenant du rail d'alimentation 42. Le courant bobine $I_{BOB}$, initialement nul, croît alors pour dépasser le courant de décollage $I_D$ : à partir de ce moment, le noyau 34 commence à se déplacer de sa position ouverte vers sa position fermée. Le noyau 34 arrive ensuite en butée mécanique. Au cours de la phase dynamique P21, le courant bobine $I_{BOB}$ présente d'importantes variations, en lien notamment avec les phénomènes d'auto-induction de la bobine 32, alors que le noyau mobile 34 se déplace au sein de la bobine 32. À l'issue de la phase dynamique P21, le contacteur 1 est à l'état fermé de manière stable.

La phase dynamique P21 se termine à un instant $t_1$ et est suivie d'une phase de transition P22, au cours de laquelle le courant bobine $I_{BOB}$ est abaissé jusqu'à un courant de maintien $I_{MN}$, le courant de maintien $I_{MN}$ étant strictement supérieur au courant de décrochage $I_S$, de manière que le contacteur 1 reste toujours à l'état fermé. La phase de transition P22 se termine à un instant $t_2$. À titre d'illustration, dans l'exemple de la figure 3 la phase de transition P22 dure environ 40 ms.

Au cours de la phase de transition P22, l'interrupteur d'alimentation T2 est ouvert, autrement dit le rapport cyclique $\alpha$ est nul, tandis que l'interrupteur de retombée T1 reste fermé : le circuit de commande 51 est dans un mode dit « roue libre ». De manière générale, en mode roue libre la bobine 32 n'est pas alimentée en énergie électrique par le rail d'alimentation 42, et la tension bobine $U_{BOB}$ est imposée passivement par le circuit de commande 51. En particulier, la tension bobine $U_{BOB}$ est imposée par les composants électroniques du circuit de commande 51. Le courant bobine $I_{BOB}$ décroit librement, l'énergie électrique étant principalement dissipée par la résistance bobine $R_{BOB}$.

En particulier, en mode roue-libre, la tension bobine $U_{BOB}$ peut être évaluée sans nécessiter de mesure. Dans l'exemple illustré, en mode roue-libre la tension bobine $U_{BOB}$ est imposée par une tension de seuil de la diode roue-libre Drl.

À l'issue de la phase de transition P22, le courant bobine $I_{BOB}$ est égal au courant de maintien $I_{MN}$. Pour éviter que le courant bobine $I_{BOB}$ ne décroisse en deçà du courant de maintien $I_{MN}$, le dispositif de contrôle 40 ajuste le rapport cyclique $\alpha$ à une valeur non nulle : la phase P3 commence alors. La phase P3 correspond à une phase de maintien, au cours de laquelle le courant bobine $I_{BOB}$ est maintenu au-dessus du courant de décrochage $I_S$.

La phase de maintien P3 comprend ici une première portion stable P31, qui commence à l'instant $t_2$ et au cours de laquelle le courant bobine $I_{BOB}$ est stable, grâce à la régulation du dispositif de contrôle 40. Au cours de la première portion P31, le rapport cyclique $\alpha$ est sensiblement constant. La première portion P31 est suivie d'une deuxième portion P32, au cours de laquelle le courant bobine $I_{BOB}$ présente un pic de courant, avec une portion croissante, suivie d'une portion décroissante pendant laquelle le circuit de commande 51 est dans le mode de roue libre. La deuxième portion P32 correspond à une phase de test, qui est détaillée plus loin. La phase de test P32 commence à un instant $t_3$, se termine à un instant $t_4$ et est suivie d'une troisième portion P33, similaire à la première portion stable P31, au cours de laquelle le courant bobine $I_{BOB}$ est stable.

On s'intéresse à présent aux grandeurs électriques et électromagnétiques de la bobine 32 en mode roue-libre de l'appareil de commutation 1. Durant la phase de roue libre, l'équation régissant la relation entre le courant et la tension bobine est :

$$U_{BOB} = R_{BOB} \cdot I_{BOB} + L_{BOB} \frac{dI_{BOB}}{dt} \qquad [Math\ 1]$$

Sur un intervalle de temps $\Delta t$ suffisamment petit pour que le courant bobine $I_{BOB}$ puisse être considéré comme constant, l'équation Math 1 peut être simplifiée pour évaluer simplement l'inductance bobine $L_{BOB}$ avec une erreur d'approximation acceptable :

$$L_{BOB} = \frac{U_{BOB} - R_{BOB} \cdot I_{BOB}}{\Delta I_{BOB}/\Delta t} \qquad [Math\ 2]$$

dans laquelle $U_{BOB}$ dépend du circuit de commande 51 et est évalué sans mesure, tandis que $R_{BOB}$ est obtenu préalablement, de préférence est enregistrée dans le dispositif électronique de contrôle 40. Ainsi, en mode roue-libre, la seule mesure du courant bobine $I_{BOB}$ suffit pour évaluer l'inductance bobine $L_{BOB}$., les valeurs de tension bobine $U_{BOB}$ et de résistance bobine $R_{BOB}$ étant préalablement connues. La résistance bobine $R_{BOB}$ dépend notamment d'une température de la bobine 32. Il est donc recommandé, pour la précision du calcul, d'évaluer la résistance bobine $R_{BOB}$. Lorsqu'il n'est pas possible d'évaluer simplement résistance bobine $R_{BOB}$, on choisit pour la résistance bobine $R_{BOB}$ une valeur nominale, correspondant à une valeur de la résistance bobine $R_{BOB}$ à température ambiante, par exemple à 25°C. La valeur nominale de la résistance bobine $R_{BOB}$ est par exemple mesurée lors de la fabrication de l'actionneur 30, ou bien encore est une valeur donnée dans les spécifications du fabricant de la bobine 32.

En pratique, l'intervalle de temps $\Delta t$ présente une durée comprise entre 0,01 ms et 10 ms, de préférence comprise entre 0,1 ms et 1 ms, notamment égale à 0,2 ms.

Pour réduire l'erreur liée aux incertitudes et/ou au bruit des mesures, le calcul de l'inductance bobine $L_{BOB}$ est répété plusieurs fois, au cours de plusieurs intervalles de temps $\Delta t$ successifs, pendant une même phase de roue libre. Les intervalles de temps $\Delta t$ sont par exemple consécutifs. Une valeur moyenne, notée $\overline{L_{BOB}}$, de l'inductance bobine $L_{BOB}$ au cours de cette phase de roue libre est ensuite calculée. Pour calculer la valeur moyenne $\overline{L_{BOB}}$, la valeur de l'inductance bobine $L_{BOB}$ est moyennée sur au moins dix intervalles de temps $\Delta t$, de préférence sur au moins vingt intervalles de temps $\Delta t$.

L'actionneur électromagnétique 30 comprend un circuit magnétique réalisé en un matériau. Le noyau mobile 34 fait notamment partie du circuit magnétique de l'actionneur électromagnétique 30. Lorsqu'une saturation magnétique du matériau du noyau mobile 34 se rapproche d'une saturation maximale de ce matériau, la perméabilité magnétique de ce matériau se rapproche de la perméabilité magnétique de l'air. En conséquence, le degré de certitude sur la distinction entre l'état ouvert ou l'état fermé de l'actionneur électromagnétique 30, évalué à partir des mesures d'inductance bobine $L_{BOB}$, décroit.

La saturation magnétique du matériau est fonction du champ magnétique généré par la bobine 32, autrement dit fonction de paramètres fixés par construction, tels que la géométrie de la bobine 32, les matériaux utilisés, le nombre de spire N, etc., et fonction du courant bobine $I_{BOB}$.

L'inductance bobine $L_{BOB}$ est avantageusement calculée à partir de mesures du courant bobine $I_{BOB}$ réalisées dans un domaine du courant bobine $I_{BOB}$ où le matériau du circuit magnétique présente une saturation magnétique inférieure à 80% d'une saturation magnétique maximale de ce matériau, de préférence inférieure à 50%.

Dans l'exemple illustré, le noyau magnétique 34 est réalisé en fer et présente une saturation magnétique de l'ordre de 2 T - Tesla -. Les mesures d'inductance bobine $L_{BOB}$ sont ainsi réalisées pour une saturation magnétique inférieure à 1,6 T, de préférence inférieure à 1 T.

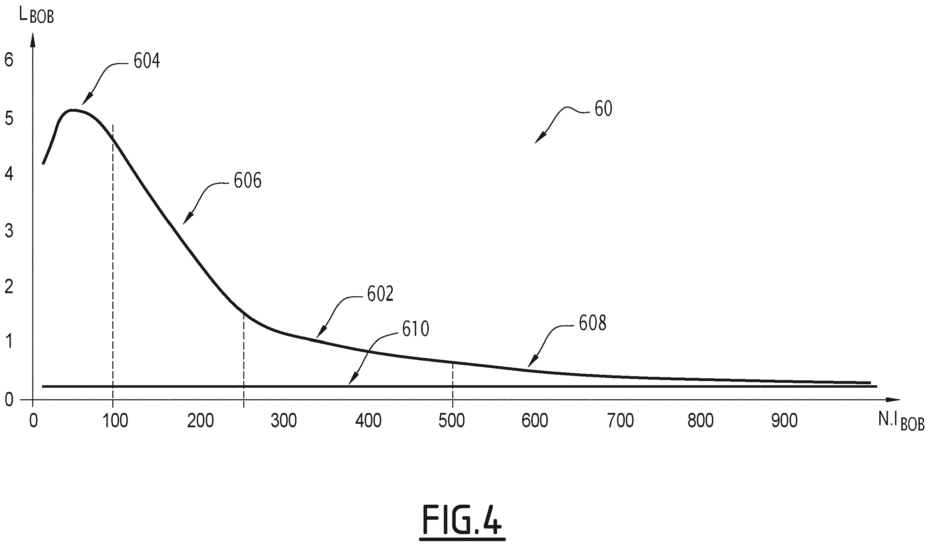

La figure 4 représente un graphique 60 illustrant ce phénomène de saturation pour une bobine 32 spécifique. Le graphique 60 illustre, en mode roue-libre, l'évolution l'inductance bobine $L_{BOB}$ de la bobine 32, en fonction d'un nombre d'Ampère-tours $N \times I_{BOB}$, égal au produit du courant bobine $I_{BOB}$ multiplié par le nombre de spires N de la bobine 32. La valeur maximale d'Ampère-tours $N \times I_{BOB}$ est représentative d'une saturation magnétique de la bobine 32. La figure 4 sert à illustrer la définition d'un domaine préférentiel d'implémentation de la méthode d'estimation selon l'invention, aussi les mesures d'inductance $L_{BOB}$ sont ici réalisées au moyen d'un capteur spécifique, qui n'est pas nécessaire pour la mise en oeuvre de l'invention.

Une première courbe 602 illustre l'évolution de l'inductance bobine $L_{BOB}$ lorsque l'actionneur électromagnétique 30 est ouvert, autrement dit lorsque le noyau 34 est en position ouverte stable. La courbe 602 présente un maximum 604 pour un nombre d'Ampères-tours $N \times I_{BOB}$ compris entre 0 et 100, suivi d'une portion décroissante 606 avec une pente forte entre 100 et 250, puis une portion décroissante 608 avec une pente plus faible au-delà de 250.

Une deuxième courbe 610 illustre une mesure de l'inductance bobine $L_{BOB}$ lorsque l'actionneur électromagnétique 30 est fermé, autrement dit lorsque le noyau 34 est en position fermée stable. La courbe 610 est sensiblement constante, quelque soit le nombre d'Ampères-tours $N \times I_{BOB}$

Lorsque le nombre d'Ampères-tours $N \times I_{BOB}$ croît au-delà de 500, les courbes 602 et 610 sont relativement proches l'une de l'autre et tendent vers une même valeur. Comptetenu des imprécisions de mesures, une évaluation de l'inductance bobine $L_{BOB}$ ne permet pas de bien distinguer, avec une confiance suffisante, si l'actionneur électromagnétique 30 est à l'état ouvert ou fermé. Autrement dit, une trop forte saturation du circuit magnétique de l'actionneur 30 nuit à la différentiation des états ouvert ou fermé de l'actionneur électromagnétique 30.

Dans le cas présent d'un actionneur électromagnétique 30 à structure linéaire à réluctance variable, lorsque le circuit magnétique est peu saturé, on constate une forte différentiation de l'inductance bobine $L_{BOB}$ entre les positions ouvertes et fermées du noyau 34. En pratique, l'inductance bobine $L_{BOB}$ est calculée à partir des valeurs de courant bobine mesurés pour lesquels la valeur d'un nombre d'Ampères-tours $N \times I_{BOB}$, égal au produit du courant bobine par le nombre de spires N de la bobine 32, est inférieur à 500.

Lorsque le nombre d'Ampères-tours $N \times I_{BOB}$ est inférieur à 500, les courbes 602 et 604 sont bien séparées, autrement dit une évaluation de l'inductance bobine $L_{BOB}$ permet de distinguer, avec une confiance suffisante, si l'actionneur électromagnétique 30 est à l'état ouvert ou fermé. La confiance est encore plus grande lorsque le nombre d'Ampèrestours $N \times I_{BOB}$ est inférieur à 250, voire inférieur à 100.

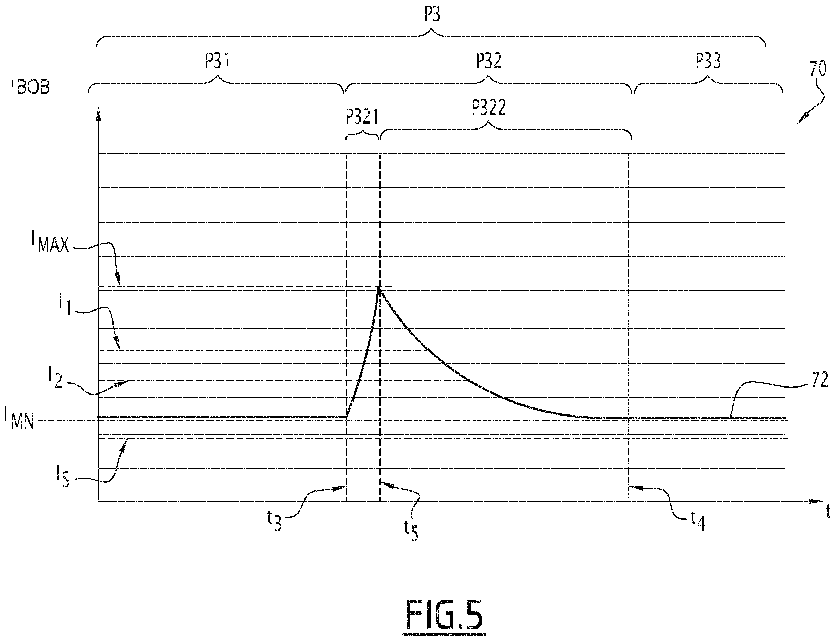

La figure 5 représente un graphique 70 illustrant la mise en oeuvre de la méthode décrite ci-dessus au cours de la phase de maintien P3, plus précisément pendant la phase de test P32. Sur la figure 5, une courbe 72 représente l'évolution du courant bobine $I_{BOB}$ au cours du temps.

Pendant la phase de maintien P31, le dispositif de contrôle 40 ajuste le rapport cyclique $\alpha$ de manière que le courant bobine $I_{BOB}$ est égal au courant de maintien $I_{MN}$. Le rapport cyclique $\alpha$ est généralement constant, et égal à une valeur de maintien $\alpha_{MN}$. LE courant bobine $U_{BOB}$ est lui aussi constant.

À l'instant $t_3$, le dispositif de contrôle 40 ajuste le rapport cyclique $\alpha$ de manière que le courant bobine $I_{BOB}$ croisse jusqu'à une valeur maximale, notée $I_{MAX}$, qui est atteinte à un instant $t_5$. Les instants $t_3$ et $t_5$ délimitent donc une portion croissante P321 du courant bobine $I_{BOB}$. Plus le rapport cyclique $\alpha$ est proche de 1, et plus le courant bobine $I_{BOB}$ croit rapidement de $I_{MN}$ à $I_{MAX}$ entre les instants $t_3$ et $t_5$. Plus le rapport cyclique $\alpha$ est proche de $\alpha_{MN}$, tout en étant strictement supérieur à $\alpha_{MN}$, et plus le courant bobine $I_{BOB}$ croit lentement au cours de la portion croissante P321.

À partir de l'instant $t_5$, le dispositif de contrôle 40 met le dispositif de commande 30 en mode roue-libre, c'est-à-dire que l'interrupteur d'alimentation T2 reste ouvert, le rapport cyclique $\alpha$ étant égal à zéro. Le courant bobine $I_{BOB}$ décroit librement, jusqu'à ce que le courant bobine $I_{BOB}$ atteigne, à l'instant $t_4$, le courant de maintien $I_{MN}$ : les instants $t_5$ et $t_4$ délimitent donc une portion décroissante P322 de la phase de test P32, pendant laquelle l'actionneur 30 est en mode roue libre.

La troisième portion P33 commence à partir de l'instant $t_4$, le dispositif de contrôle 40 ajustant à nouveau le rapport cyclique $\alpha$ à la valeur de maintien $\alpha_{MN}$, pour que le courant bobine $I_{BOB}$ reste stable et égal au courant de maintien $I_{MN}$. Autrement dit, le pic de courant bobine $I_{BOB}$ de la phase de test P32 est appliqué à l'aide du dispositif électronique de contrôle 40 au cours de la phase de maintien P3 du contacteur 1.

Au cours de la portion décroissante P322, l'inductance bobine $L_{BOB}$ est mesurée entre une première borne $I_1$ et une deuxième borne $I_2$ du courant bobine $I_{BOB}$, strictement inférieure à la première borne $I_1$, la première borne $I_1$ et la deuxième borne $I_2$ étant comprises entre le courant maximal $I_{MAX}$ et le courant de maintien $I_{MN}$. La première borne $I_1$ et la deuxième borne $I_2$ sont choisies pour réduire au maximum les effets transitoires mais aussi pour que la saturation magnétique du noyau 34 reste inférieure à 80% de la saturation magnétique maximale de ce noyau 34. Dans l'exemple illustré, la première borne $I_1$ présente ici une valeur médiane entre le courant de maintien $I_{MN}$ et le courant maximal $I_{MAX}$ de la phase de test P32, tandis que la deuxième borne $I_2$ présente ici une valeur médiane entre le courant de maintien $I_{MN}$ et la première borne $I_1$ du courant bobine $I_{BOB}$. Autrement dit, dans l'exemple illustré $I_1 = 1,5 \times I_{MN}$, et $I_2 = 1,25 \times I_{MN}$.

La valeur maximale $I_{MAX}$ est avantageusement choisie de manière que la portion décroissante P322 dure suffisamment longtemps pour calculer l'inductance bobine $L_{BOB}$ selon la méthode précédemment décrite basée sur l'équation Math 2. Comme mentionné précédemment, plusieurs mesures successives du courant bobine $I_{BOB}$ sont réalisées, de manière à calculer la valeur moyenne $\overline{L}_{BOB}$ de l'inductance bobine $L_{BOB}$. La durée de la portion décroissante P322 est ici comprise entre 35 ms et 40 ms, et la valeur maximale $I_{MAX}$ du courant bobine $I_{BOB}$ est ici choisie égale à deux fois le courant de maintien $I_{MN}$, autrement dit $I_{MAX} = 2 \times I_{MN}$. Au cours de la phase de montée P321, le rapport cyclique $\alpha$ est choisi pour que la durée de la phase de montée P321 soit comprise entre 3 ms et 10 ms, par exemple égale à 5 ms. Bien entendu d'autres valeurs de $I_{MAX}$ et de rapport cyclique $\alpha$ peuvent être choisies, selon les besoins, pour ajuster les durées des portions croissante P321 ou décroissante P322.

Dans le calcul de l'inductance bobine $L_{BOB}$, la résistance bobine $R_{BOB}$ est préalablement connue. Par défaut, la valeur de la résistance bobine $R_{BOB}$ est égale à la valeur nominale de la résistance bobine $R_{BOB}$.

Lorsque l'inductance bobine $L_{BOB}$ est calculée au cours d'une phase de test P32, cette phase de test P32 est précédée d'une phase stable P31, au cours de laquelle le courant bobine $I_{BOB}$ est constant, et égal au courant de maintien $I_{MN}$. Les termes dérivés de l'équation Math 1 étant nuls, la résistance bobine $R_{BOB}$ se déduit avantageusement par la relation simple de la loi d'Ohm :

$$R_{BOB} = \frac{U_{BOB}}{I_{BOB}}$$

Afin de minimiser les erreurs liées au bruit de mesure du courant bobine $I_{BOB}$ et de la tension bobine $U_{BOB}$, la résistance bobine $R_{BOB}$ est calculée plusieurs fois au cours d'un intervalle temporel inclus dans la portion stable P31, et les résultats de ces calculs de résistance bobine $R_{BOB}$ sont moyennés pour obtenir une valeur précise de la résistance bobine $R_{BOB}$. Par exemple, dix calculs successifs de la résistance bobine $R_{BOB}$ sont réalisés sur un intervalle de 10 ms, pour calculer une valeur moyenne de la résistance bobine $R_{BOB}$.

Cette valeur moyenne permet un calcul plus précis de l'inductance bobine $L_{BOB}$, et permet, indirectement, de remonter à une meilleure estimation de la position du noyau 34 de l'actionneur 30. La connaissance précise de la résistance bobine $R_{BOB}$ peut aussi être mise à profit pour estimer la température de la bobine 32.

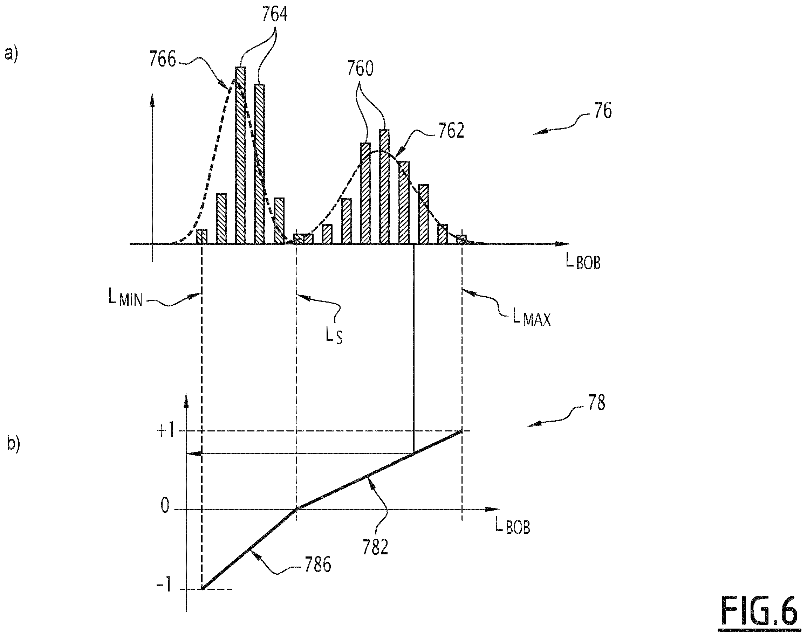

La figure 6 présente, sur l'insert a), un graphe 76 illustrant la distribution statistique de la valeur de l'inductance bobine $L_{BOB}$ de l'actionneur 30, selon l'état ouvert ou fermé de l'actionneur 30. L'inductance bobine $L_{BOB}$ est ici calculée par simulation numérique de l'actionneur 30.

De nombreuses méthodes de simulation numérique existent. Avantageusement, les paramètres critiques du système simulé sont identifiés par un plan d'expérience, les plages de variation respectives de ces paramètres critiques étant identifiées et combinées. À titre d'exemples non limitatifs, les paramètres critiques peuvent inclure un ou plusieurs paramètres parmi les paramètres géométriques des éléments ferromagnétiques et du bobinage de l'actionneur électromagnétique 1, les paramètres physiques des matériaux utilisés, les tolérances sur les composants électroniques intervenant dans le contrôle ou la mesure, etc.

Un premier histogramme 760 correspond aux valeurs d'inductance bobine $L_{BOB}$ calculées à partir de mesures du courant bobine $I_{BOB}$ réalisées lorsque à l'actionneur 30 est à l'état ouvert. Une première fonction de distribution 762 est déduite du premier histogramme 760. Dans l'exemple illustré, la première fonction de distribution 762 présente une forme de Gaussienne et est située sur la droite du graphe 76.

Un deuxième histogramme 764 correspond aux valeurs d'inductance bobine $L_{BOB}$ calculées à partir de mesures du courant bobine $I_{BOB}$ réalisées lorsque l'actionneur 30 est à l'état fermé. Une deuxième fonction de distribution 766 est déduite du deuxième histogramme 764. Dans l'exemple, la deuxième fonction de distribution 766 présente aussi une forme de Gaussienne et est située sur la gauche du graphe 76.

On remarque que les deux fonctions de distribution 762 et 766 sont bien distinctes, notamment grâce au fait que la saturation magnétique du matériau du noyau 34 est maintenue inférieure à 80% de la saturation magnétique maximale de ce matériau. En pratique, dans l'exemple illustré, le nombre d'Ampères-tours $N \times I_{BOB}$ est inférieur à 500. Il est donc possible, à partir d'un calcul de l'inductance bobine $L_{BOB}$, de déterminer avec une haute probabilité si l'actionneur électromagnétique 30 est à l'état ouvert ou fermé. Autrement dit, l'inductance bobine $L_{BOB}$ est un indicateur fiable de l'état de l'actionneur électromagnétique 30.

On appelle Ls une valeur seuil de l'inductance bobine $L_{BOB}$ permettant de différencier les deux fonctions de distribution 762 et 766. Ainsi la première fonction 762 regroupe des valeurs s'étendant entre la valeur seuil Ls et, tandis que la deuxième fonction 766 regroupe des valeurs s'étendant entre une valeur minimale $L_{MIN}$ et la valeur seuil Ls.

La valeur de l'inductance bobine $L_{BOB}$ est avantageusement normalisée pour que l'indicateur soit plus facile à utiliser, de manière qu'en résultat de la normalisation, l'indicateur de l'état du contacteur soit égal à -1 lorsque la valeur de l'inductance bobine $L_{BOB}$ est égale à la valeur minimale $L_{MIN}$, +1 lorsque la valeur de l'inductance bobine $L_{BOB}$ est égale à la valeur maximale $L_{MAX}$, et 0 la valeur de l'inductance bobine $L_{BOB}$ est égale à la valeur de seuil $L_S$.

Plusieurs fonctions de normalisation existent ; dans le cas présent une normalisation par fonctions affines est choisie, car particulièrement simple d'utilisation et donnant de bons résultats.

La figure 6 présente, sur l'insert b), un graphe 78 représentant deux fonctions affines de normalisation, appliqué ici à l'inductance bobine $L_{BOB}$.

Une première portion 782 donne une valeur 0 lorsque l'inductance bobine $L_{BOB}$ est égale à la valeur seuil $L_S$, et donne une valeur +1 lorsque l'inductance bobine $L_{BOB}$ est égale à la valeur maximale $L_{MAX}$.

Une deuxième portion 786 donne une valeur -1 lorsque l'inductance bobine $L_{BOB}$ est égale à la valeur minimale $L_{MIN}$, et donne une valeur 0 lorsque l'inductance bobine $L_{BOB}$ est égale à la valeur seuil $L_S$.

Ainsi, pour chaque valeur calculée de l'inductance bobine $L_{BOB}$, en entrée de la fonction de normalisation, on obtient une unique valeur de sortie de l'inductance bobine $L_{BOB}$ normalisée.

De manière générale, lorsque plusieurs indicateurs de l'état de l'actionneur électromagnétique 30 sont disponibles, ces indicateurs sont avantageusement combinés entre eux, pour résulter en un indicateur global encore plus robuste de l'état de l'actionneur électromagnétique 30. Bien entendu, les indicateurs combinés entre eux sont normalisés pour indiquer la même valeur lorsque le contacteur 1 est dans un état donné.

Dans le cas présent, outre la valeur de l'inductance bobine $L_{BOB}$ qui résulte en un premier indicateur, une ou plusieurs autres grandeurs électriques du contacteur 1 sont mesurées, chaque autre mesure de grandeur électrique étant aussi normalisée, pour résulter en un indicateur global sur l'état de l'appareil de commutation.

De manière schématique, pour chaque autre mesure de grandeur électrique, on détermine ainsi une valeur minimale et une valeur maximale de cette grandeur électrique dans les divers états de fonctionnement du contacteur 1, ainsi qu'une valeur de seuil permettant de différencier les états du contacteur 1. Il en découle deux fonctions affines, qui permettent de normaliser les valeurs calculées pour chaque grandeur électrique entre -1 et +1.

Selon les besoins, l'opérateur est libre d'envisager la combinaison de deux, trois, voire plus, grandeurs électriques normalisées, pour former un indicateur global robuste.

Un indicateur global formé à partir de deux grandeurs électriques normalisée varie ainsi entre -2 et +2. Une valeur proche de -2 ou +2 permet d'identifier avec une grande certitude l'état du contacteur 1, tandis qu'une valeur proche de 0 indique que les deux grandeurs électriques normalisées donnent des résultats contradictoires, signalant potentiellement une anomalie de fonctionnement du contacteur 1.

Un indicateur global formé à partir de trois grandeurs électriques normalisée varie ainsi entre -3 et +3. Par exemple, une valeur comprise entre -3 et -1, ou bien entre +1 et +3, permet d'identifier avec une grande certitude l'état du contacteur 1, tandis qu'une valeur comprise entre -1 et +1 signale une anomalie de fonctionnement.

Un deuxième exemple de grandeur électrique est un flux magnétique $\phi$ de la bobine 32, qui est calculé à partir de mesures réalisées au cours de la phase de test P32. De manière générale, lorsque le courant bobine $I_{BOB}$ circule dans la bobine 32, un flux magnétique $\phi$ est généré. La valeur du flux magnétique $\phi$ dépend notamment de la valeur du courant bobine $I_{BOB}$ et de la position du noyau mobile 34.

Par exemple, la valeur du flux magnétique $\phi$ est liée aux valeurs de tension bobine $U_{BOB}$ et de courant bobine $I_{BOB}$ selon l'équation suivante, notée Math 3 dans ce qui suit :

$$U_{BOB} = R_{BOB} \cdot I_{BOB} + N\frac{d\phi}{dt} \qquad [Math\,3]$$

dans laquelle N est le nombre de spires de la bobine 32, et $\phi$ est le flux magnétique résultant du champ magnétique créé dans la bobine 32.

On définit une position $x$ comme une position du noyau 34 par rapport à la bobine 32. Dans de nombreux modes de réalisation, le noyau 34 peut se déplacer en translation par rapport à la bobine 32 le long d'un axe de déplacement. La position $x$ est alors définie le long de cet axe de déplacement. Par convention, la position $x$ est nulle lorsque le contacteur 1 est à l'état ouvert. Pour chacune des phases électriques du contacteur 1, la position des contacts mobiles 24 est ainsi reliée à la position $x$. Par extension, la position $x$ représente aussi une position de l'actionneur électromagnétique 30 ou du contacteur 1.

En dérivant $\phi$ dans l'équation Math 3, on obtient une équation générale Math 4 régissant les grandeurs électromagnétiques dans l'actionneur 30 :

$$U_{BOB} = R_{BOB} \cdot I_{BOB} + N\frac{d\phi}{dI_{BOB}}\frac{dI_{BOB}}{dt} + N\frac{d\phi}{dx}\frac{dx}{dt} + N\frac{d\phi}{di_f}\frac{di_f}{dt} \quad [Math\,4]$$

dans laquelle le dernier terme $N\dfrac{d\phi}{di_f}\dfrac{di_f}{dt}$ fait intervenir des courants d'induction, aussi dits courants de Foucault, notés $i_f$, N désignant le nombre de spires de la bobine 34.

Les courants induits étant négligés, le circuit magnétique présente une reluctance *Rel* qui est, d'une part, fonction de la position $x$ du noyau mobile 34 et du courant bobine $I_{BOB}$, et qui est, d'autre part, liée au flux magnétique $\phi$ et au courant bobine $I_{BOB}$ par la relation suivante, dite relation d'Hopkinson : $Rel(x, I_{BOB}) \cdot \phi = N \cdot I_{BOB}$.

La reluctance *Rel* variant avec la position $x$ de l'actionneur 30, il est possible de déterminer une image de cette position $x$ au travers du ratio $\Delta I_{BOB}(t)/\Delta\phi(t)$, N étant constant.

Pendant la phase de test P32, la position $x$ est stabilisée, tandis que $I_{BOB}$, et donc le flux magnétique $\phi$, varient.

On peut ainsi écrire : $Rel(x, I_{BOB}) \cdot \Delta\phi(t) = N \cdot \Delta I_{BOB}(t)$.

Sur un intervalle $\Delta I_{BOB}$ constant et pré-determiné, la variation du flux magnétique $\Delta\phi$ est donc l'image de la position $x$ du noyau 34. Autrement dit, le calcul du flux magnétique $\phi$ permet de déterminer une image de la position $x$ lors d'une phase de croissance ou de décroissance du courant bobine $I_{BOB}$. L'équation Math 3 devient, par intégration temporelle au cours de la phase de test P32 :

$$\phi = \int \frac{U_{BOB} - R_{BOB} \cdot I_{BOB}}{N_{BOB}} dt \qquad [Math\ 5]$$

dans laquelle le courant bobine $I_{BOB}$ est mesuré, la résistante bobine $R_{BOB}$ et le nombre de spires $N_{BOB}$ sont préalablement connus, et la tension bobine $U_{BOB}$ est évaluée. En particulier, la tension bobine $U_{BOB}$ est pilotée par le dispositif électronique de contrôle 40 qui agit sur le rapport cyclique $\alpha$. La tension bobine $U_{BOB}$ est donnée par la relation suivante :

$$U_{BOB} = \alpha \cdot (V_{rect} - Vloss_{ON}) + (1 - \alpha) \cdot (Vloss_{OFF})$$

dans laquelle $Vrect$ est la tension du rail d'alimentation 42, et $Vloss_{ON}$ et $Vloss_{OFF}$ sont respectivement les chutes de tension cumulées de tous les composants en série de la bobine 32, placés entre le rail d'alimentation 42 et la bobine 32, lorsque l'interrupteur d'alimentation T2 est respectivement fermé, ou ouvert. Les chutes de tension $Vloss_{ON}$ et $Vloss_{OFF}$ dépendent notamment des composants électroniques et de l'architecture du circuit de commande 51. Ainsi la tension bobine $U_{BOB}$ est évaluée sans mesure directe, mais simplement à partir du rapport cyclique $\alpha$, connu car piloté par le dispositif électronique de commande 40, et à partir des composants du circuit de commande 51 et de la tension $Vrect$ du rail d'alimentation 42.

Au cours de la portion croissante P321, le rapport cyclique $\alpha$ est non nul, et le courant bobine $I_{BOB}$ est croissant. Par intégration temporelle de l'équation Math 4 entre les instants $t_3$ et $t_5$, on obtient une première valeur d'un flux magnétique, notée $\Delta\phi_{UP}$ - Delta Phi Up -. Le courant bobine $I_{BOB}$ croit, depuis le courant de maintien $I_{MN}$ jusqu'au courant maximal $I_{MAX}$.

Au cours de la portion décroissante P322, le rapport cyclique $\alpha$ est nul, et le courant bobine $I_{BOB}$ est décroissant. Par intégration temporelle de l'équation Math 4 entre les instants $t_5$ et $t_4$, on obtient une deuxième valeur d'un flux magnétique, notée $\Delta\phi_{DOWN}$ - Delta Phi Down -. Le courant bobine $I_{BOB}$ décroit, depuis le courant maximal $I_{MAX}$ jusqu'au courant de maintien $I_{MN}$.

Les deux valeurs calculées de flux magnétique $\Delta\phi_{UP}$ et $\Delta\phi_{DOWN}$ sont ensuite comparés à un intervalle normalisé, permettant d'obtenir un indicateur fiable et robuste sur l'état de l'actionneur 30. Selon les cas, les deux valeurs de flux magnétiques $\Delta\phi_{UP}$ et $\Delta\phi_{DOWN}$ sont utilisées séparément, ou bien en combinaison. La tension $U_{BOB}$ étant différente au cours des phases croissante P321 ou décroissante P322, on peut ainsi mitiger d'éventuelles erreurs liées à l'estimation de la tension bobine $U_{BOB}$.

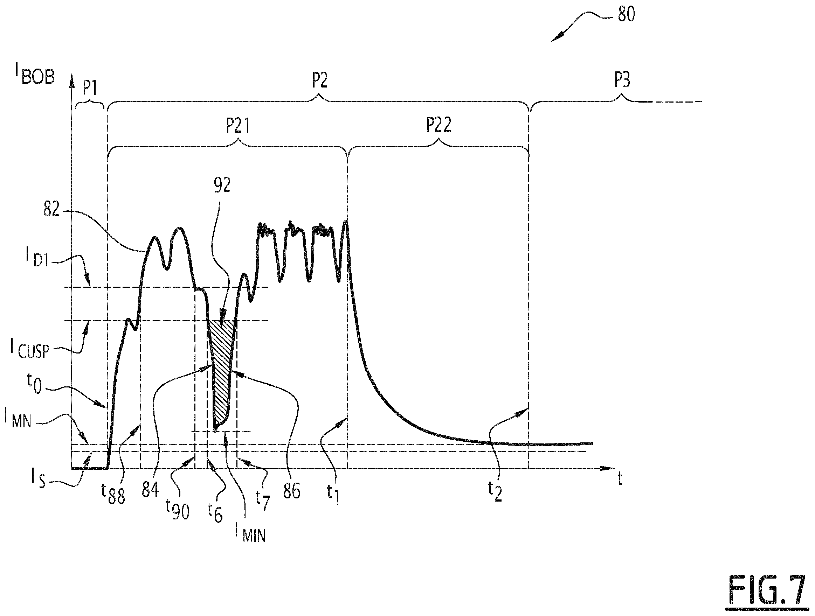

Un troisième exemple de mesure de grandeur électrique est décrit, en référence à la figure 7, qui représente un graphe 80 avec une courbe 82 illustrant l'évolution du courant bobine $I_{BOB}$ au cours d'une phase de fermeture P2 du contacteur 1.

Sur les structures d'actionneur 30 à réluctance variable, la force électromotrice liée à la variation de flux magnétique $\phi$, elle-même liée à la variation de position $x$ du noyau 34, induit une variation de la tension bobine $I_{BOB}$ lors du déplacement de la partie mobile de l'actionneur 30. Ce phénomène correspond au terme $N\frac{d\phi}{dx}\frac{dx}{dt}$ de l'équation Math 4 : en phase de fermeture, cela se traduit par une chute de la tension bobine $U_{BOB}$ causée par l'apparition d'une force électromotrice, fonction de la vitesse de variation du flux magnétique $\phi$, et donc de la vitesse de déplacement. Le courant bobine $I_{BOB}$ chute également, et il existe un lien entre cette chute de courant bobine $I_{BOB}$ et la position de la partie mobile de l'actionneur 30, autrement dit la position $x$ du noyau 34.

Dit autrement, le déplacement du noyau 34 se traduit par une chute du courant bobine $I_{BOB}$, qui correspond à une portion décroissante 84 de la courbe 82. Lorsque le noyau 34 arrive en butée en position fermée, le courant bobine $I_{BOB}$ remonte, sous l'influence de la tension bobine $U_{BOB}$ pilotée par le dispositif électronique de contrôle 40. La remontée du courant bobine $I_{BOB}$ correspond à une portion croissante 86 de la courbe 82, qui suit la portion décroissante 84. Le courant bobine $I_{BOB}$ atteint une valeur minimale $I_{MIN}$ entre les phases décroissante 84 et croissante 86.

Au cours de la phase de fermeture, le mouvement du noyau 34 commence lorsque le courant bobine $I_{BOB}$ dépasse un premier seuil de courant $I_{D1}$, à un instant $t_{88}$ sur la figure 7. Dans l'exemple, le premier seuil $I_{D1}$ est lié au courant de décollage $I_D$, par exemple égal à 90% du courant de décollage $I_D$. Alors que le noyau 34 se déplace, l'inductance bobine $L_{BOB}$ augmente, générant sur le noyau une force électromagnétique croissante : la chute du courant bobine $I_{BOB}$ ne se traduit donc pas par un retour du noyau 34 vers sa position ouverte. Sous l'effet des phénomènes décrits ci-dessus, le courant bobine $I_{BOB}$ décroît en deçà du premier seuil de courant $I_{D1}$, à un instant $t_{90}$, atteint la valeur minimale $I_{MIN}$, puis augmente à nouveau, et dépasse une deuxième fois le premier seuil $I_{D1}$.

On définit un deuxième seuil $I_{CUSP}$ comme étant une valeur du courant bobine $I_{BOB}$ strictement comprise entre le premier seuil $I_{D1}$ et le courant minimum $I_{MIN}$. Par exemple, le deuxième seuil $I_{CUSP}$ est égal à 80% du premier seuil $I_{D1}$. Au cours de la portion décroissante 84, l'évolution du courant bobine $I_{BOB}$ décroit en deçà du deuxième seuil $I_{CUSP}$ à un instant $t_6$, tandis qu'au cours de la portion croissante 86, l'évolution du courant bobine $I_{BOB}$ repasse au-dessus du deuxième seuil $I_{CUSP}$ à un instant $t_7$.

Le deuxième seuil $I_{CUSP}$, les portions décroissante 84 et croissante 86 délimitent une zone 92, représentée hachurée sur la figure 7. Une surface de la zone 92 est donc égale à l'intégrale, sur un intervalle de temps défini entre les instants te et $t_7$, de la différence entre le courant bobine $I_{BOB}$ et le seuil de courant $I_{CUSP}$, lorsque le courant bobine $I_{BOB}$ est inférieur au seuil de courant $I_{CUSP}$.

Comme décrit précédemment, plus la fermeture est rapide, ce qui témoigne d'un bon fonctionnement de l'actionneur 30, et plus la chute de courant bobine $I_{BOB}$ est franche, ce qui se traduit par une zone 92 plus grande. Autrement dit, à condition que l'évolution du courant bobine $I_{BOB}$ dépasse une deuxième fois le premier seuil $I_{D1}$, la surface de la zone 92 est un indicateur du bon fonctionnement de l'actionneur 30 : le résultat du calcul de la surface de la zone 92 est ensuite normalisé suivant la méthode décrite précédemment, de manière à obtenir un indicateur fiable sur la bonne fermeture de l'actionneur 30 au cours de la phase de fermeture P2.

Un quatrième exemple de mesure de grandeur électrique est le calcul de l'inductance bobine $L_{BOB}$, à l'aide de l'équation Math 2, au cours de la phase de transition P22, qui est aussi une phase de roue libre au cours de laquelle le noyau 34 est stable.

Plus généralement, on comprend que de nombreuses combinaisons d'indicateurs normalisés à partir de mesures et/ou de calculs de grandeurs électriques sont possibles, différentes grandeurs électriques pouvant être mesurée au cours des diverses phases de fonctionnement de l'actionneur 30. Les mesures de ces grandeurs électriques peuvent être simultanées, ou bien décalées dans le temps et enregistrées dans le dispositif électronique de contrôle 40.

Avantageusement, l'indicateur global est formé par une somme des indicateurs normalisés qui le composent, c'est-à-dire que chaque indicateur normalisé à la même pondération que les autres. En variante, les indicateurs normalisés ont des pondérations différentes.

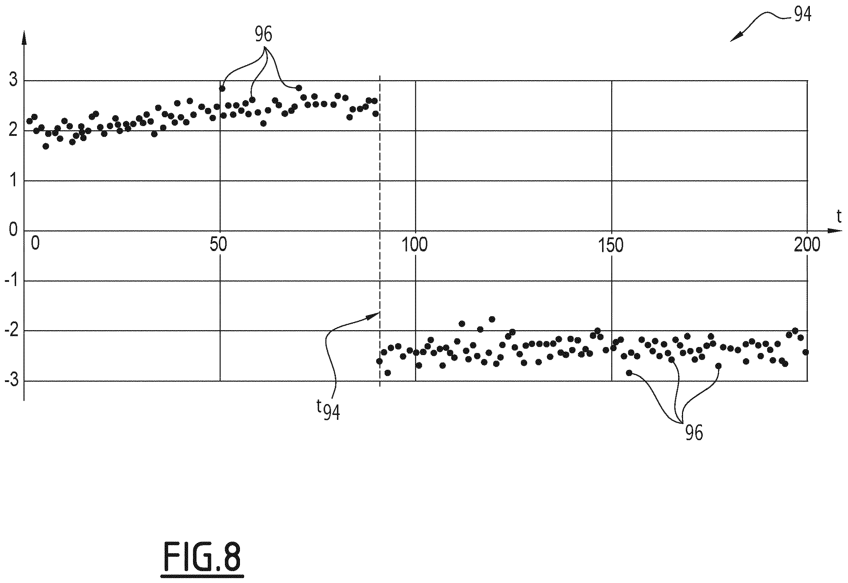

La figure 8 représente un graphe 94, illustrant les résultats de deux cents calculs d'un indicateur global formé à partir des mesures de trois grandeurs électriques, qui sont ensuite normalisées et sommées. L'indicateur global varie donc ici entre -3 et +3. Dans cet exemple, les trois grandeurs électriques considérées sont l'inductance bobine $L_{BOB}$, et les valeurs de flux magnétique $\Delta\phi_{UP}$ et $\Delta\phi_{DOWN}$. Les paramètres critiques influant sur ces trois grandeurs électriques ainsi que les plages de variation respectives de ces paramètres sont définis au travers d'un plan d'expérience. Les calculs de ces trois grandeurs électriques sont réalisés en faisant varier l'ensemble des paramètres critiques sur l'intégralité de leurs plages de variation respectives.

Les résultats sont présentés sous la forme d'un nuage de points. Un premier nuage 96, sur la gauche du graphe 94, correspond aux résultats des calculs lorsque l'actionneur 30 est en position fermée, tandis qu'un deuxième nuage de points 98, sur la droite du graphe 94, correspond au cas où l'actionneur 30 est en position ouverte. Le nuage de point 96 évolue sensiblement entre 2 et 2,5, ce qui indique que, alors que chaque paramètre critique évolue sur l'ensemble de sa plage de variation respective, l'indicateur global résulte en une valeur relativement stable, donc robuste. Autrement dit, malgré les variations de tous les paramètres critiques considérés, les trois mesures de grandeurs électriques normalisées indiquent, de manière concordante, que l'appareil de commutation 1 est fermé. Si l'un des indicateurs normalisés était discordant, par exemple égal à -0,5, alors l'indicateur global serait, au maximum, égal à 2 - 0,5 = 1,5. Une telle valeur intermédiaire témoignerait d'un dysfonctionnement potentiel de l'appareil de commutation 1.

De manière analogue, le nuage de points 98 évolue sensiblement entre -2 et -2,5. Là encore, les trois grandeurs électriques normalisées indiquent, de manière concordante, que l'appareil de commutation 1 est ouvert.

La distinction franche entre les deux nuages de points 96 et 98, correspondant respectivement aux états fermé et ouvert de l'actionneur 30, témoigne de la robustesse de l'indicateur global décrit dans cet exemple.

Une fois qu'un indicateur global de l'état de l'actionneur 30 est défini de manière robuste, il est encore possible de combiner le résultat de cet indicateur à d'autres grandeurs complémentaires, représentatives du fonctionnement de l'appareil de commutation 1, afin de procéder à un diagnostic du fonctionnement de l'appareil de commutation 1.

Un premier exemple de grandeur complémentaire est la détection d'un courant de pôle, circulant dans chacune des phases de la ligne amont 20 du contacteur 1. Une telle détection est par exemple réalisée à l'aide des capteurs de courant 46 : le passage d'un courant de pôle traversant un pôle du conducteur électrique témoigne de l'état fermé du contracteur 1. À titre d'illustration, si un courant de pôle est détecté alors que l'indicateur global de l'état de l'actionneur 30 indique que ce dernier est ouvert, alors l'incohérence des deux résultats témoigne d'une anomalie de fonctionnement de l'appareil de commutation 1.

Optionnellement, la grandeur relative à la détection d'un courant de pôle est normalisée pour être intégrée à l'indicateur global décrit précédemment. Par exemple, lorsque les capteurs de courant 46 détectent un courant de pôle, l'indicateur normalisé associé est égal à +1, tandis que lorsque les capteurs 46 ne détectent aucun courant de pôle, l'indicateur normalisé associé est égal à -1.

Un deuxième exemple de mesure de grandeur complémentaire est un état de commande du dispositif électronique de contrôle 40.

Là aussi, optionnellement, cette deuxième grandeur complémentaire peut être normalisée pour être intégrée à l'indicateur global décrit précédemment. Par exemple, lorsque le dispositif de contrôle 40 envoie une commande d'état fermé, l'indicateur normalisé associé est égal à +1, tandis que lorsque le dispositif de contrôle 40 envoie une commande d'état ouvert, l'indicateur normalisé associé est égal à -1.

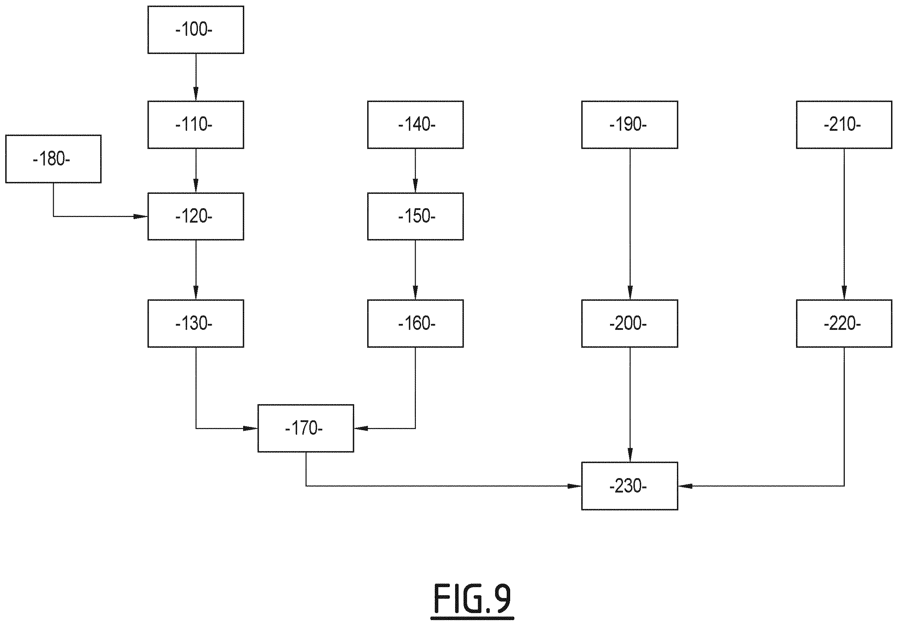

Un exemple de fonctionnement d'un procédé d'estimation de propriétés du contacteur 1 selon un mode de réalisation préféré est maintenant décrit en référence à la figure 9. Cependant, en variante, les étapes de ce procédé pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

Au cours d'une étape préalable 100, le procédé est initialisé, alors que l'actionneur électromagnétique 30 est dans une position stable, par exemple une position stable de fermeture.

Ensuite, au cours d'une étape 110, on mesure, au moyen de capteurs associés à la bobine 32, des valeurs du courant bobine $I_{BOB}$, pendant que l'actionneur 30 est maintenu dans une position stable.

Ensuite, au cours d'une étape 120, on calcule, au moyen du dispositif électronique de contrôle 40 du contacteur 1, une ou plusieurs valeurs d'un flux magnétique $\phi$ de la bobine 32, à partir de la valeur de courant bobine $I_{BOB}$ mesurée, et à l'aide de valeurs de tension bobine $U_{BOB}$ et de résistance bobine $R_{BOB}$ préalablement connues.

Ensuite, au cours d'une étape 130, la ou les valeurs de flux magnétique $\phi$ sont normalisées.

Au cours d'une étape 140, qui est selon les cas antérieure, postérieure, ou conjointe à l'étape 130, on mesure au moins une autre grandeur électrique du contacteur 1. Optionnellement, une ou plusieurs de ces grandeurs électriques mesurées à l'étape 140 sont utilisées pour calculer, à une étape 150, d'autres grandeurs électriques.

Un premier exemple d'autre grandeur électrique est l'inductance bobine $L_{BOB}$, qui est calculée, à l'étape 150, à partir de mesures de courant bobine $I_{BOB}$ réalisées à l'étape 140 au moyen des capteurs Rsh associés à la bobine 32.

Un deuxième exemple d'autre grandeur électrique est l'intégrale 92 de la différence entre le courant bobine $I_{BOB}$ et le deuxième seuil de courant $I_{CUSP}$, calculée, à l'étape 150, à partie de mesures réalisées au cours de la phase dynamique P21 de la phase de fermeture P2 tel que défini précédemment.

Ensuite, au cours d'une étape 160, au moins une des grandeurs électriques mesurées à l'étape 140 ou calculée à l'étape 150 est normalisée.

Ensuite, au cours d'une étape 170, postérieure aux étapes 130 et 160, la valeur normalisée du flux magnétique $\phi$, obtenue à l'étape 130, est combinée à au moins une autre grandeur électrique normalisée du contacteur 1, obtenue à l'étape 160, pour résulter en un indicateur global sur l'état du contacteur 1.

Avantageusement, lorsqu'à l'étape 100 la phase de roue libre correspond à une portion décroissante P322 d'une phase de test P32, laquelle est précédée d'une portion stable P31 de la phase de maintien P3, au cours de laquelle l'actionneur 30 est excité en position stable de fermeture et le courant bobine $I_{BOB}$ est stable, alors l'étape 120 est précédée d'une étape 180, au cours de laquelle la résistance bobine $R_{BOB}$ est calculée, pendant cette portion stable P31, par le rapport de la tension bobine $U_{BOB}$ divisé par le courant bobine $I_{BOB}$, autrement dit à partir de la loi d'Ohm

$$R_{BOB} = \frac{V_{BOB}}{I_{BOB}}$$

. On obtient ainsi, à l'issue de l'étape 180, une mesure précise de la résistance bobine $R_{BOB}$, tenant compte notamment de la température de la bobine 32. À l'étape 120, le calcul du flux magnétique $\phi$, qui est réalisé en utilisant la valeur mesurée de la résistance bobine $R_{BOB}$ plutôt qu'une valeur préalablement enregistrée dans le dispositif électronique de contrôle 40, est ainsi plus précis. Bien entendu, lorsqu'une valeur mesurée de la résistance bobine $R_{BOB}$ est disponible, cette valeur mesurée est aussi utilisée pour le calcul des autres grandeurs électriques, notamment l'inductance bobine $L_{BOB}$, calculée à l'étape 150.

L'indicateur global obtenu à l'étape 170 est ensuite avantageusement combiné, au cours d'une étape 230, à une ou plusieurs autres grandeurs électriques complémentaires, qui sont mesurées puis éventuellement normalisées.

Un premier exemple de grandeur électrique complémentaire est un courant de pôle, qui est mesuré à une étape 190, puis éventuellement normalisé à une étape 200. Un deuxième exemple de grandeur électrique complémentaire est un état de commande du dispositif électronique de contrôle 40, qui est mesuré à une étape 210, puis éventuellement normalisé à une étape 220.

Dans l'exemple illustré, les grandeurs électriques sont mesurées alors que l'appareil de commutation 1 est dans un état stable de fermeture, ou bien dans une phase de fermeture. Les principes décrits sont transposables au cas où l'appareil de commutation 1 est à l'état ouvert stable. En variante non représentée, lorsque le courant bobine

$I_{BOB}$ est nul, le dispositif électronique de contrôle 40 ajuste le rapport cyclique $\alpha$ pour générer un pic de courant bobine $I_{BOB}$ strictement inférieur au courant de décollage $I_D$. Le rapport cyclique $\alpha$ étant ensuite annulé : l'appareil de commutation 1 est alors en mode roue-libre. Il est alors possible, au cours de cette phase de roue-libre, de mesurer plusieurs grandeurs électriques telles que l'inductance bobine $L_{BOB}$ selon les principes décrits précédemment, ou bien encore un flux magnétique $\Delta\phi_{DOWN}$, etc. Ces grandeurs électriques sont ensuite normalisées et combinées entre elles, de manière à former un indicateur global des états de l'actionneur électromagnétique 30.

Les modes de réalisation et les variantes mentionnées ci-dessus peuvent être combinés entre eux pour générer de nouveaux modes de réalisation de l'invention.

## Revendications

1. Procédé pour estimer l'état d'un appareil de commutation électrique (1), l'appareil de commutation comportant des contacts électriques séparables (24, 28) configurés pour être couplés à un conducteur électrique (20), et un actionneur électromagnétique (30), piloté par un circuit de commande (51) et comportant un noyau mobile (34), couplé aux contacts séparables, et une bobine (32), traversée par un courant bobine ($I_{BOB}$),
**caractérisé en ce que** le procédé comporte des étapes consistant à :

   - mesurer (110), au moyen de capteurs (Rsh) associés à la bobine (32), des valeurs du courant bobine ($I_{BOB}$) au cours d'un intervalle de temps ($\Delta t$), pendant que l'actionneur électromagnétique (30) est maintenu dans une position stable, notamment de fermeture,
   - calculer (120), au moyen d'un dispositif électronique de contrôle (40) de l'appareil de commutation (1), une ou plusieurs valeurs d'un flux magnétique ($\phi$) de la bobine (32) à partir des valeurs de courant bobine ($I_{BOB}$) mesurées, et à l'aide de valeurs de tension bobine ($U_{BOB}$) et de résistance bobine ($R_{BOB}$) préalablement connues.

2. Procédé selon la revendication 1, dans lequel les une ou plusieurs valeurs d'un flux magnétique ($\phi$) sont calculées par intégration de la formule Math 5 ci-dessous :

$$\phi = \int \frac{U_{BOB} - R_{BOB} \cdot I_{BOB}}{N_{BOB}} dt \qquad [Math\,5]$$

dans laquelle $N_{BOB}$ est un nombre de spires de la bobine (32).

3. Procédé selon l'une quelconque des revendications 1 ou 2, dans lequel une première valeur du flux magnétique ($\Delta\phi_{DOWN}$) est calculée à partir de mesures du courant bobine ($I_{BOB}$) réalisées alors que l'appareil de commutation (1) est dans un mode de roue-libre (P22, P322), dans lequel la tension bobine ($U_{BOB}$) est limitée passivement par le circuit de commande (51), tandis que le courant bobine ($I_{BOB}$) décroit librement, l'énergie électrique étant principalement dissipée par la résistance bobine ($R_{BOB}$).

4. Procédé selon la revendication 3, lequel une deuxième valeur du flux magnétique ($\Delta\phi_{UP}$) est calculée à partir de mesures du courant bobine ($I_{BOB}$) réalisées au cours d'une portion croissante (P21, P321) qui précède immédiatement la phase de roue libre au cours de laquelle sont réalisées les mesures du courant bobine ($I_{BOB}$) servant au calcul de la première valeur de flux magnétique ($\Delta\phi_{DOWN}$), la tension bobine ($U_{BOB}$) étant imposée par le circuit de commande (51).

5. Procédé selon la revendication 4, dans lequel la première valeur du flux magnétique ($\Delta\phi_{DOWN}$) et la deuxième valeur du flux magnétique ($\Delta\phi_{UP}$) sont calculées à partir de mesures du courant bobine ($I_{BOB}$) réalisées au cours d'une phase de fermeture (P2) de l'appareil de commutation (1).

6. Procédé selon la revendication 4, dans lequel un pic de courant bobine ($I_{BOB}$) est appliqué à l'aide du dispositif électronique de contrôle (40) au cours d'une phase de test (P32) inclue dans une phase de maintien (P3) de l'appareil de commutation (1), au cours de laquelle le courant bobine ($I_{BOB}$) présente une valeur de courant de maintien ($I_{MN}$) strictement supérieure à une valeur de décrochage ($I_S$) du courant bobine, en deçà de laquelle l'actionneur électromagnétique (30) n'est pas maintenu excité en position de fermeture, l'évolution du courant bobine ($I_{BOB}$) présentant une portion croissante (P321), au cours de laquelle sont réalisées les mesures du courant bobine ($I_{BOB}$) servant au calcul de la deuxième valeur du flux magnétique ($\Delta\phi_{UP}$), et une portion décroissante (P322), au cours de laquelle sont réalisées les mesures du courant bobine ($I_{BOB}$) servant au calcul de la première valeur du flux magnétique

$(\Delta\phi_{DOWN})$.

7. Procédé selon la revendication 6, dans lequel la résistance bobine ($R_{BOB}$) est mesurée (180) au cours d'une portion stable (P31) de la phase de maintien (P3), qui précède la phase de test (P32), la valeur mesurée de la résistance bobine ($R_{BOB}$) étant ensuite utilisée à l'étape de calcul (120) de la deuxième valeur du flux magnétique ($\Delta\phi_{UP}$) et de la première valeur du flux magnétique ($\Delta\phi_{DOWN}$) au cours de ladite phase de test.

8. Procédé selon l'une quelconque des revendications 1 à 7, dans lequel la ou les valeurs calculées de flux magnétique ($\phi$) sont normalisées (130) et combinées (170) à au moins une autre grandeur électrique, mesurée (140) et/ou calculée (150), de l'appareil de commutation (1), chaque autre mesure de grandeur électrique étant aussi normalisée (160), pour résulter en un indicateur intermédiaire sur l'état de l'actionneur électromagnétique (30).

9. Procédé selon la revendication 8, dans lequel :

   - une phase de fermeture (P2) de l'appareil de commutation (1) comprend une phase dynamique (P21), au cours de laquelle la tension bobine ($U_{BOB}$) est pilotée par le dispositif électronique de commande (40), suivie d'une phase de transition (P22), au cours de laquelle l'appareil de commutation (1) est dans un mode de roue-libre,
   - au cours de la phase dynamique (P21) l'évolution du courant bobine ($I_{BOB}$) augmente une première fois au-delà d'un premier seuil ($I_{D1}$), qui est lié à un courant de décollage ($I_D$) de l'appareil de commutation (1) au-delà duquel le noyau mobile (34) commence à se déplacer de sa position d'ouverture vers sa position de fermeture, puis l'évolution du courant bobine ($I_{BOB}$) décroît en deçà du premier seuil ($I_{D1}$), atteint une valeur minimale ($I_{MIN}$), puis repasse une deuxième fois au-delà du premier seuil ($I_{D1}$) ;
   - on définit un deuxième seuil ($I_{CUSP}$) du courant bobine ($I_{BOB}$), le deuxième seuil ($I_{CUSP}$) étant compris entre le premier seuil ($I_{D1}$) et la valeur minimale ($I_{MIN}$),
   - alors que le courant bobine ($I_{BOB}$) mesuré (140) est inférieur au deuxième seuil ($I_{CUSP}$), et à condition que l'évolution du courant bobine dépasse une deuxième fois le premier seuil ($I_{D1}$), on calcule (150) une intégrale (92) de la différence entre le courant bobine ($I_{BOB}$) et le deuxième seuil ($I_{CUSP}$), sur un intervalle de temps défini entre un premier instant ($t_6$) où l'évolution du courant bobine ($I_{BOB}$) décroît en deçà du deuxième seuil ($I_{CUSP}$) et un deuxième instant ($t_7$) où le courant bobine repasse au-dessus du deuxième seuil,

   et dans lequel ladite intégrale (92) est l'une des autres grandeurs électriques combinées (170) pour former l'indicateur intermédiaire.

10. Procédé selon la revendication 8, dans lequel :

   - on mesure (140), au moyen de capteurs (Rsh) associés à la bobine (32), une valeur du courant bobine ($I_{BOB}$) au cours d'un intervalle de temps ($\Delta t$), pendant que l'actionneur électromagnétique (30) est maintenu dans une position stable, notamment de fermeture, et que l'appareil de commutation (1) est dans un mode de roue-libre, dans lequel la tension bobine ($U_{BOB}$) est limitée passivement par le circuit de commande (51), tandis que le courant bobine ($I_{BOB}$) décroit librement, l'énergie électrique étant principalement dissipée par la résistance bobine ($R_{BOB}$) ,
   - on calcule (150), au moyen d'un dispositif électronique de contrôle (40) de l'appareil de commutation (1), une valeur d'inductance bobine ($L_{BOB}$) de la bobine (32) à partir de la valeur de courant bobine ($I_{BOB}$) mesurée, et à l'aide de valeurs de tension bobine ($U_{BOB}$) et de résistance bobine ($R_{BOB}$) préalablement connues ;

   et dans lequel l'inductance bobine ($L_{BOB}$) est l'une des autres grandeurs électriques utilisées pour former l'indicateur intermédiaire.

11. Procédé selon la revendication 10, dans lequel l'actionneur électromagnétique (30) comprend un circuit magnétique réalisé en un matériau, dans lequel l'inductance bobine ($L_{BOB}$) est calculée (150) à partie de mesures (140) du courant bobine ($I_{BOB}$) réalisées dans un domaine du courant bobine ($I_{BOB}$) où le matériau du circuit magnétique présente une saturation magnétique inférieure à 80% d'une saturation magnétique maximale de ce matériau, de préférence inférieure à 50%.

12. Procédé selon l'une quelconque des revendications 10 ou 11, dans lequel les étapes de mesure (140) du courant bobine ($I_{BOB}$) et de calcul (150) de l'inductance bobine ($L_{BOB}$) sont répétées au cours de plusieurs intervalles de

temps ($\Delta$t), une valeur d'inductance moyenne ($\overline{L}_{BOB}$) étant déduite à partir des valeurs d'inductance bobine calculées au cours de chaque intervalle de temps,

dans lequel chaque intervalle de temps ($\Delta$t) présente une durée comprise entre 0,01 ms et 10 ms, de préférence comprise entre 0,1 ms et 1 ms, de préférence encore égale à 0,2 ms, et dans lequel la valeur de l'inductance bobine ($L_{BOB}$) est moyennée sur au moins dix (10) intervalles de temps, de préférence sur au moins vingt (20) intervalles de temps.

13. Procédé selon l'une quelconque des revendications 8 à 12, dans lequel l'une des autres mesures (180) de grandeur électrique est une mesure d'un courant de pôle, traversant un pôle du conducteur électrique (20), et/ou un état de commande du dispositif électronique de contrôle (40).

14. Appareil de commutation électrique (1) pour la mise en oeuvre d'un procédé d'estimation conforme à l'une quelconque des revendication 1 à 11, l'appareil de commutation étant configuré pour être couplé à un conducteur électrique (20) et comprenant :

- des contacts séparables (24, 28), déplacés entre une position ouverte et une position fermée par un actionneur électromagnétique (30) comprenant une bobine (32) et un noyau mobile (34) lié aux contacts séparables,
- un circuit de commande (51) de la tension électrique aux bornes de la bobine (32), dite « tension bobine » ($U_{BOB}$), le circuit de commande comprenant un dispositif dit « de retombée » (Dz), activable sélectivement pour faire chuter le courant électrique circulant au travers de la bobine, dit « courant bobine » ($I_{BOB}$), la tension bobine et le dispositif de retombée étant activés ou désactivés selon des états du circuit de commande (51) ;
- des capteurs (Rsh) associés à la bobine pour mesurer le courant bobine ;
- un dispositif électronique de contrôle (40), configuré pour recevoir des ordres d'ouverture et de fermeture de l'appareil de commutation (1), pour recevoir les valeurs des mesures de courant bobine et pour commander les états du circuit de commande ;

**caractérisé en ce que**, alors que l'actionneur électromagnétique (30) est maintenu dans une position stable, notamment de fermeture, l'appareil de commutation (1) est configuré pour mettre en oeuvre un procédé de diagnostic comprenant des étapes consistant à :

- mesurer (110), au moyen des capteurs (Rsh) associés à la bobine (32), des valeurs de courant bobine ($I_{BOB}$) au cours d'un intervalle de temps ($\Delta$t) ,
- calculer (120), au moyen du dispositif électronique de contrôle (40), une valeur d'un flux magnétique ($\phi$) de la bobine (32) à partir des valeurs de courant bobine mesurées, et à l'aide de valeurs, préalablement connues, de la tension bobine ($U_{BOB}$) et de résistance bobine ($R_{BOB}$).

## Patentansprüche

1. Verfahren zum Einschätzen des Betriebszustands eines elektrischen Schaltgeräts (1), wobei das Schaltgerät trennbare elektrische Kontakte (24, 28) umfasst, die so konfiguriert sind, dass sie mit einem elektrischen Leiter (20) gekoppelt werden können, und einem elektromagnetischen Aktuator (30), der von einer Steuerschaltung (51) gesteuert wird und einen beweglichen Kern (34) enthalten, der mit den trennbaren Kontakten gekoppelt ist, sowie eine Spule (32), durch die ein Spulenstrom ($I_{BOB}$) fließt,

**dadurch gekennzeichnet, dass** das Verfahren Schritte umfasst, die aus Folgendem bestehen:

- Messen (110), mittels Sensoren (Rsh), die der Spule (32) zugeordnet sind, von Werten des Spulenstroms ($I_{BOB}$) während eines Zeitintervalls ($\Delta$t), während der elektromagnetische Aktuator (30) in einer stabilen, insbesondere geschlossenen Position gehalten wird,
- Berechnen (120), mittels einer elektronischen Steuervorrichtung (40) des Schaltgeräts (1), eines oder mehrerer Werte eines magnetischen Flusses ($\Phi$) der Spule (32) aus den gemessenen Spulenstromwerten ($I_{BOB}$) und unter Verwendung von zuvor bekannten Werten der Spulenspannung ($U_{BOB}$) und des Spulenwiderstands ($R_{BOB}$).

2. Verfahren nach Anspruch 1, wobei der eine oder die mehreren Werte eines magnetischen Flusses ($\Phi$) durch Integration der nachstehenden Formel Math 5 berechnet werden:

$$\phi = \int \frac{U_{BOB} - R_{BOB} \cdot I_{BOB}}{N_{BOB}} dt \qquad \text{[Math 5]}$$

wobei $N_{BOB}$ eine Anzahl von Windungen der Spule (32) ist.

3. Verfahren nach einem der Ansprüche 1 oder 2, bei dem ein erster Wert des magnetischen Flusses ($\Delta\Phi_{DOWN}$) aus Messungen des Spulenstroms ($I_{BOB}$) berechnet wird, die durchgeführt werden, während sich das Schaltgerät (1) in einem Freilaufmodus (P22, P322) befindet, in dem die Spulenspannung ($U_{BOB}$) passiv durch die Steuerschaltung (51) begrenzt wird, während der Spulenstrom ($I_{BOB}$) frei abnimmt, wobei die elektrische Energie hauptsächlich durch den Spulenwiderstand ($R_{BOB}$) dissipiert wird.

4. Verfahren nach Anspruch 3, bei dem ein zweiter Wert des magnetischen Flusses ($\Delta\Phi_{UP}$) aus Messungen des Spulenstroms ($I_{BOB}$) berechnet wird, die während eines ansteigenden Abschnitts (P21, P321) durchgeführt werden, der unmittelbar vor der Freilaufphase liegt, in der die Messungen des Spulenstroms ($I_{BOB}$) durchgeführt werden, die zur Berechnung des ersten Werts des magnetischen Flusses ($\Delta\Phi_{DOWN}$) dienen, wobei die Spulenspannung ($U_{BOB}$) von der Steuerschaltung (51) vorgegeben wird.

5. Verfahren nach Anspruch 4, wobei der erste Wert des magnetischen Flusses ($\Delta\Phi_{DOWN}$) und der zweite Wert des magnetischen Flusses ($\Delta\Phi_{UP}$) aus Messungen des Spulenstroms ($I_{BOB}$) berechnet werden, die während einer Schließphase (P2) des Schaltgeräts (1) durchgeführt werden.

6. Verfahren nach Anspruch 4, bei dem eine Spulenstromspitze ($I_{BOB}$) mit Hilfe der elektronischen Steuervorrichtung (40) während einer Testphase (P32) angelegt wird, die in einer Haltephase (P3) des Schaltgeräts (1) enthalten ist, während der der Spulenstrom ($I_{BOB}$) einen Haltestromwert ($I_{MN}$) aufweist, der strikt über einem Abklingwert ($I_S$) des Spulenstroms liegt, bei dessen Unterschreitung der elektromagnetische Aktuator (30) nicht erregt in geschlossener Position gehalten wird, der Verlauf des Spulenstroms ($I_{BOB}$) weist einen ansteigenden Abschnitt (P321) auf, in dem die Messungen des Spulenstroms ($I_{BOB}$) durchgeführt werden, die zur Berechnung des zweiten Werts des magnetischen Flusses ($\Delta\Phi_{UP}$) dienen, und einen abnehmenden Abschnitt (P322), in dem die Messungen des Spulenstroms ($I_{BOB}$) durchgeführt werden, die zur Berechnung des ersten Wertes des magnetischen Flusses ($\Delta\Phi_{DOWN}$) dienen.

7. Verfahren nach Anspruch 6, bei dem der Spulenwiderstand ($R_{BOB}$) in einem stabilen Abschnitt (P31) der Haltephase (P3) gemessen wird (180), die vor der Testphase (P32) liegt, der gemessene Wert des Spulenwiderstands ($R_{BOB}$) wird dann in dem Schritt des Berechnens (120) des zweiten Wertes des magnetischen Flusses ($\Delta\Phi_{UP}$) und des ersten Wertes des magnetischen Flusses ($\Delta\Phi_{DOWN}$) während der Testphase verwendet.

8. Verfahren nach einem der Ansprüche 1 bis 7, bei dem der berechnete Wert oder die berechneten Werte des magnetischen Flusses ($\Phi$) normiert (130) und mit mindestens einer weiteren gemessenen (140) und/oder berechneten (150) elektrischen Größe des Schaltgeräts (1) kombiniert (170) werden, wobei jede weitere Messung der elektrischen Größe ebenfalls normiert (160) wird, um in einem Zwischenindikator über den Zustand des elektromagnetischen Aktuators (30) zu resultieren.

9. Verfahren nach Anspruch 8, wobei:

  - eine Schließphase (P2) des Schaltgeräts (1) eine dynamische Phase (P21) umfasst, in der die Spulenspannung ($U_{BOB}$) durch die Steuerelektronik (40) gesteuert wird, gefolgt von einer Übergangsphase (P22), in der sich das Schaltgerät (1) in einem Freilaufmodus befindet,
  - während der dynamischen Phase (P21) der Verlauf des Spulenstroms ($I_{BOB}$) ein erstes Mal über einen ersten Schwellenwert ($I_{D1}$) ansteigt, der mit einem Abhebestrom ($I_D$) des Schaltgeräts (1) verbunden ist, über dem der bewegliche Kern (34) beginnt, sich von seiner Öffnungsposition in seine Schließposition zu bewegen, dann nimmt die Entwicklung des Spulenstroms ($I_{BOB}$) unterhalb des ersten Schwellenwerts ($I_{D1}$) ab, erreicht einen Minimalwert ($I_{MIN}$) und geht dann ein zweites Mal über den ersten Schwellenwert ($I_{D1}$) hinaus;
  - ein zweiter Schwellenwert ($I_{CUSP}$) des Spulenstroms ($I_{BOB}$) definiert wird, wobei der zweite Schwellenwert ($I_{CUSP}$) zwischen dem ersten Schwellenwert ($I_{D1}$) und dem Minimalwert ($I_{MIN}$) liegt,
  - während der gemessene (140) Spulenstrom ($I_{BOB}$) unterhalb des zweiten Schwellenwerts ($I_{CUSP}$) liegt, und unter der Bedingung, dass die Entwicklung des Spulenstroms den ersten Schwellenwert ($I_{D1}$) ein zweites Mal überschreitet, wird ein Integral (92) der Differenz zwischen dem Spulenstrom ($I_{BOB}$) und dem zweiten Schwellenwert ($I_{CUSP}$) berechnet (150), über ein Zeitintervall, das zwischen einem ersten Zeitpunkt (te), in dem die Entwicklung des Spulenstroms ($I_{BOB}$) unterhalb der zweiten Schwelle ($I_{CUSP}$) abnimmt, und einem zweiten Zeitpunkt ($t_7$), in dem der Spulenstrom wieder über die zweite Schwelle ansteigt, definiert ist,

und wobei das Integral (92) eine der anderen kombinierten elektrischen Größen (170) ist, um den Zwischenindikator zu bilden.

10. Verfahren nach Anspruch 8, wobei:

- mittels der Spule (32) zugeordneter Sensoren (Rsh) ein Wert des Spulenstroms ($I_{BOB}$) während eines Zeitintervalls ($\Delta t$) gemessen (140) wird, während der elektromagnetische Aktuator (30) in einer stabilen, insbesondere geschlossenen Position gehalten wird und sich das Schaltgerät (1) in einem Freilaufmodus befindet, in dem die Spulenspannung ($U_{BOB}$) durch eine resistive Widerstandskraft begrenzt wird, wobei die Spulenspannung passiv durch die Steuerschaltung (51) begrenzt wird, während der Spulenstrom ($I_{BOB}$) frei abnimmt, wobei die elektrische Energie hauptsächlich über den Spulenwiderstand ($R_{BOB}$) abgeleitet wird,
- mittels einer elektronischen Steuervorrichtung (40) des Schaltgeräts (1) ein Spuleninduktivitätswerts ($L_{BOB}$) der Spule (32) aus dem gemessenen Spulenstromwert ($I_{BOB}$) und unter Verwendung von zuvor bekannten Spulenspannungswerten ($U_{BOB}$) und Spulenwiderstandswerten ($R_{BOB}$) berechnet (150) wird;

und wobei die Spuleninduktivität ($L_{BOB}$) eine der anderen elektrischen Größen ist, die zur Bildung des Zwischenindikators verwendet werden.

11. Verfahren nach Anspruch 10, wobei der elektromagnetische Aktuator (30) einen Magnetkreis umfasst, der aus einem Material hergestellt ist, wobei die Spuleninduktivität ($L_{BOB}$) aus Messungen (140) des Spulenstroms ($I_{BOB}$) berechnet (150) wird, die in einem Bereich des Spulenstroms ($I_{BOB}$) durchgeführt werden, in dem das Material des magnetischen Kreises eine magnetische Sättigung von weniger als 80 % einer maximalen magnetischen Sättigung dieses Materials, vorzugsweise von weniger als 50 %, aufweist.

12. Verfahren nach einem der Ansprüche 10 oder 11, bei dem die Schritte des Messens (140) des Spulenstroms ($I_{BOB}$) und des Berechnens (150) der Spuleninduktivität ($L_{BOB}$) in mehreren Zeitintervallen ($\Delta t$) wiederholt werden, wobei ein mittlerer Induktivitätswert ($\overline{L}_{BOB}$) aus den in jedem Zeitintervall berechneten Werten der Spuleninduktivität abgeleitet wird, wobei jedes Zeitintervall ($\Delta t$) eine Dauer zwischen 0,01 ms und 10 ms, vorzugsweise zwischen 0,1 ms und 1 ms, besonders bevorzugt gleich 0,2 ms aufweist, der Wert der Spuleninduktivität ($L_{BOB}$) wird über mindestens zehn (10) Zeitintervalle, vorzugsweise über mindestens zwanzig (20) Zeitintervalle, gemittelt.

13. Verfahren nach einem der Ansprüche 8 bis 12, wobei eine der anderen Messungen (180) einer elektrischen Größe eine Messung eines Polstroms, der durch einen Pol des elektrischen Leiters (20) fließt, und/oder eines Steuerzustands der elektronischen Steuervorrichtung (40) ist.

14. Elektrisches Schaltgerät (1) zur Durchführung eines Schätzverfahrens gemäß einem der Ansprüche 1 bis 11, wobei das Schaltgerät so konfiguriert ist, dass es mit einem elektrischen Leiter (20) gekoppelt werden kann, und Folgendes umfasst:

- trennbare Kontakte (24, 28), die zwischen einer offenen und einer geschlossenen Position durch einen elektromagnetischen Aktuator (30) bewegt werden, der eine Spule (32) und einen beweglichen Kern (34) umfasst, der mit den trennbaren Kontakten verbunden ist,
- eine Steuerschaltung (51) der elektrischen Spannung an den Klemmen der Spule (32), genannt "Spulenspannung" ($U_{BOB}$), wobei die Steuerschaltung eine sogenannte "Rückfallvorrichtung" (Dz) umfasst, die selektiv aktiviert werden kann, um den elektrischen Strom abfallen zu lassen, der als "Spulenstrom" ($I_{BOB}$) bezeichnet wird, wobei die Spulenspannung und die Rückfallvorrichtung gemäß den Zuständen der Steuerschaltung (51) aktiviert oder deaktiviert werden;
- Sensoren (Rsh), die der Spule zugeordnet sind, um den Spulenstrom zu messen;
- eine elektronische Steuervorrichtung (40), die so konfiguriert ist, dass sie Befehle zum Öffnen und Schließen des Schaltgeräts (1) empfängt, die Werte der Spulenstrommessungen empfängt und die Zustände der Steuerschaltung steuert;

**dadurch gekennzeichnet, dass**, während der elektromagnetische Aktuator (30) in einer stabilen Position, insbesondere einer geschlossenen Position, gehalten wird, das Schaltgerät (1) so konfiguriert ist, dass es ein Diagnoseverfahren durchführt, das die folgenden Schritte umfasst:

- Messen (110), mittels der der Spule (32) zugeordneten Sensoren (Rsh), von Werten des Spulenstroms ($I_{BOB}$) während eines Zeitintervalls ($\Delta t$),
- Berechnen (120), mittels der elektronischen Steuervorrichtung (40), eines Wertes eines magnetischen Flusses ($\Phi$) der Spule (32) aus den gemessenen Spulenstromwerten und unter Verwendung von zuvor bekannten Werten der Spulenspannung ($U_{BOB}$) und des Spulenwiderstandes ($R_{BOB}$).

**Claims**

1. A method for estimating the state of an electrical switching device (1), the switching device comprising separable electrical contacts (24, 28) configured to be coupled to an electrical conductor (20), and an electromagnetic actuator (30) driven by a control circuit (51) and comprising a moving core (34) coupled to the separable contacts and a coil (32) through which a coil current ($I_{BOB}$) flows,
**characterised in that** the method comprises the steps consisting of:

   - measuring (110), by means of sensors (Rsh) associated with the coil (32), values of the coil current ($I_{BOB}$) during a time interval ($\Delta t$), while the electromagnetic actuator (30) is held in a stable position, in particular a closed position,
   - calculating (120), by means of an electronic control device (40) for controlling the switching device (1), one or more values of a magnetic flux ($\Phi$) of the coil (32) from the measured coil current ($I_{BOB}$) values, and using previously known coil voltage ($U_{BOB}$) and coil resistance ($R_{BOB}$) values.

2. The method according to claim 1, wherein the one or more values of a magnetic flux ($\Phi$) are calculated by integrating the formula Math 5 below:

$$\phi = \int \frac{U_{BOB} - R_{BOB} \cdot I_{BOB}}{N_{BOB}} \, dt \qquad [Math\ 5]$$

where $N_{BOB}$ is a number of turns of the coil (32).

3. The method according to any one of claims 1 or 2, wherein a first value of the magnetic flux ($\Delta\Phi_{DOWN}$) is calculated from measurements of the coil current ($I_{BOB}$) made while the switching apparatus (1) is in a freewheeling mode (P22, P322), wherein the coil voltage ($U_{BOB}$) is passively limited by the control circuit (51), while the coil current ($I_{BOB}$) decreases freely, the electrical energy being mainly dissipated by the coil resistance ($R_{BOB}$).

4. The method according to claim 3, wherein a second value of the magnetic flux ($\Delta\Phi_{UP}$) is calculated from measurements of the coil current ($I_{BOB}$) carried out during an increasing portion (P21, P321) immediately preceding the freewheeling phase during which the coil current ($I_{BOB}$) used to calculate the first magnetic flux value ($\Delta\Phi_{DOWN}$) is measured, the coil voltage ($U_{BOB}$) being imposed by the control circuit (51).

5. The method according to claim 4, wherein the first value of the magnetic flux ($\Delta\Phi_{DOWN}$) and the second value of the magnetic flux ($\Delta\Phi_{UP}$) are calculated from measurements of the coil current ($I_{BOB}$) made during a closing phase (P2) of the switching device (1).

6. The method according to claim 4, wherein a peak coil current ($I_{BOB}$) is applied with the aid of the electronic control device (40) during a test phase (P32) included in a retention phase (P3) for retaining the switching device (1), during which the coil current ($I_{BOB}$) has a retention current value ($I_{MN}$) strictly greater than a stall value ($I_S$) of the coil current, below which the electromagnetic actuator (30) is not kept energised in the closed position, the evolution of the coil current ($I_{BOB}$) having an increasing portion (P321), during which the measurements of the coil current ($I_{BOB}$) used to calculate the second value of the magnetic flux ($\Delta\Phi_{UP}$) and a decreasing portion (P322), during which the coil current ($I_{BOB}$) used to calculate the first value of the magnetic flux ($\Delta\Phi_{DOWN}$) is measured.

7. The method according to claim 6, wherein the coil resistance ($R_{BOB}$) is measured (180) during a stable portion (P31) of the retention phase (P3), which precedes the test phase (P32), the measured value of the coil resistance ($R_{BOB}$)

then being used in the step of calculating (120) the second value of the magnetic flux ($\Delta \Phi_{UP}$) and the first value of the magnetic flux ($\Delta \Phi_{DOWN}$) during said test phase.

8. The method according to any one of claims 1 to 7, wherein the calculated value or values of the magnetic flux ($\Phi$) are normalised (130) and combined (170) with at least one other measured (140) and/or calculated (150) electrical quantity of the switching device (1), each other electrical quantity measurement also being normalised (160), to result in an intermediate indicator of the state of the electromagnetic actuator (30).

9. The method according to claim 8, wherein:

  - a closing phase (P2) of the switching device (1) comprises a dynamic phase (P21), during which the coil voltage ($U_{BOB}$) is controlled by the electronic control device (40), followed by a transition phase (P22), during which the switching device (1) is in a freewheeling mode,
  - during the dynamic phase (P21) the change in the coil current ($I_{BOB}$) increases a first time above a first threshold ($I_{D1}$), which is linked to a starting current ($I_D$) of the switching device (1) above which the moving core (34) starts to move from its open position to its closed position, then the change in the coil current ($I_{BOB}$) decreases below the first threshold ($I_{D1}$), reaches a minimum value ($I_{MIN}$), and then again rises above the first threshold ($I_{D1}$) a second time;
  - a second threshold ($I_{CUSP}$) of the coil current ($I_{BOB}$) is defined, the second threshold ($I_{CUSP}$) lying between the first threshold ($I_{D1}$) and the minimum value ($I_{MIN}$),
  - when the coil current ($I_{BOB}$) measured (140) is less than the second threshold ($I_{CUSP}$), and on condition that the change in coil current exceeds the first threshold ($I_{D1}$) a second time, an integral (92) of the difference between the coil current ($I_{BOB}$) and the second threshold ($I_{CUSP}$) is calculated (150) over a time interval defined between a first instant ($t_6$) when the change in the coil current ($I_{BOB}$) decreases below the second threshold ($I_{CUSP}$) and a second instant ($t_7$) when the coil current again rises above the second threshold,

  and wherein said integral (92) is one of the other electrical quantities combined (170) to form the intermediate indicator.

10. The method according to claim 8, wherein:

  - by means of sensors (Rsh) associated with the coil (32), a value of the coil current ($I_{BOB}$) is measured (140) during a time interval ($\Delta t$), while the electromagnetic actuator (30) is held in a stable position, in particular a closed position, and the switching device (1) is in a freewheeling mode, wherein the coil voltage ($U_{BOB}$) is passively limited by the control circuit (51), while the coil current ($I_{BOB}$) decreases freely, the electrical energy being dissipated mainly by the coil resistance ($R_{BOB}$),
  - a coil inductance value ($L_{BOB}$) of the coil (32) is calculated (150) by means of an electronic control device (40) for controlling the switching device (1), from the measured coil current ($I_{BOB}$) values, and using previously known coil voltage ($U_{BOB}$) and coil resistance ($R_{BOB}$) values;

  and wherein the coil inductance ($L_{BOB}$) is one of the other electrical quantities used to form the intermediate indicator.

11. The method according to claim 10, wherein the electromagnetic actuator (30) comprises a magnetic circuit made of a material, wherein the coil inductance ($L_{BOB}$) is calculated (150) from measurements (140) of the coil current ($I_{BOB}$) taken in a range of the coil current ($I_{BOB}$) where the material of the magnetic circuit has a magnetic saturation of less than 80% of a maximum magnetic saturation of this material, preferably less than 50%.

12. The method according to any one of claims 10 or 11, wherein the steps of measuring (140) the coil current ($I_{BOB}$) and calculating (150) the coil inductance ($L_{BOB}$) are repeated over a plurality of time intervals ($\Delta t$), an average inductance value ($\overline{L}_{BOB}$) being deduced from the coil inductance values calculated during each time interval, wherein each time interval ($\Delta t$) has a duration of between 0.01 ms and 10 ms, preferably between 0.1 ms and 1 ms, even more preferably equal to 0.2 ms, and wherein the value of the coil inductance ($L_{BOB}$) is averaged over at least ten (10) time intervals, preferably over at least twenty (20) time intervals.

13. The method according to any one of claims 8 to 12, wherein one of the other measurements (180) of electrical magnitude is a measurement of a pole current, passing through a pole of the electrical conductor (20), and/or a control state of the electronic control device (40).

**14.** An electrical switching apparatus (1) for implementing an estimation method according to any one of claims 1 to 11, the switching device being configured to be coupled to an electrical conductor (20) and comprising:

- separable contacts (24, 28), moved between an open position and a closed position by an electromagnetic actuator (30) comprising a coil (32) and a moving core (34) linked to the separable contacts,
- a control circuit (51) for controlling the electrical voltage at the terminals of the coil (32), referred to as the "coil voltage" ($U_{bob}$), the control circuit comprising a "fallback" device (Dz) which can be activated selectively to cause the electric current flowing through the coil, referred to as the "coil current" ($I_{bob}$), to fall, the coil voltage and the fallback device being activated or deactivated depending on the states of the control circuit (51);
- sensors (Rsh) associated with the coil to measure the coil current;
- an electronic control device (40), configured to receive commands to open and close the switching device (1), to receive the values of the coil current measurement values and to control the states of the control circuit;

**characterised in that**, while the electromagnetic actuator (30) is held in a stable position, in particular a closed position, the switching device (1) is configured to implement a diagnostic method comprising steps consisting of:

- measuring (110), by means of sensors (Rsh) associated with the coil (32), coil current values ($I_{BOB}$) over a time interval ($\Delta t$),
- calculating (120), by means of the electronic control device (40), a value of a magnetic flux ($\Phi$) of the coil (32) from the measured coil current values, and using previously known values of the coil voltage ($U_{BOB}$) and coil resistance ($R_{BOB}$).

## FIG.1

## FIG.2

EP 4 040 173 B1

FIG.3

EP 4 040 173 B1

FIG.4

EP 4 040 173 B1

$$\underline{FIG.5}$$

EP 4 040 173 B1

FIG.6

FIG.7

FIG.8

EP 4 040 173 B1

FIG.9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03054895 A1
- US 6249418 B1
- US 2019074148 A1
- US 2009138212 A
- JP 2006049021 A
- EP 2984671 B1